# EUROPEAN PATENT SPECIFICATION

(11) **EP 1 826 023 B1**
(45) Date of publication and mention of the grant of the patent: **15.07.2009**
(21) Application number: 07003743.7
(22) Date of filing: 23.02.2007
(51) Int. Cl.: B41N 3/08, G03F 7/32

(54) **Method for processing lithographic printing plate precursor**
Verfahren zur Verarbeitung eines Lithografiedruckplattenvorläufers
Procédé de traitement d'un précurseur de plaque d'impression lithographique

(30) Priority: 24.02.2006 JP 2006048812
(43) Date of publication of application: 29.08.2007
(73) Proprietor: FUJIFILM Corporation, Minato-ku Tokyo (JP)
(72) Inventor: Mitsumoto, Tomoyoshi, Haibara-gun, Shizuoka (JP)
(74) Representative: HOFFMANN EITLE

(56) References cited:
- EP-A- 0 336 400
- GB-A- 1 515 174
- GB-A- 2 046 474

## Description

### Background of the Invention

### 1. Field of the Invention

The present invention relates to a method for processing a lithographic printing plate precursor. More specifically, the present invention relates to a processing method, applied to a lithographic printing plate precursor which can directly produce a printing plate by scanning a laser based on digital signals of a computer or the like and which has an image recording layer removable by a printing ink, a fountain solution or both thereof.

### 2. Description of the Related Art

The lithographic printing plate generally consists of a lipophilic image area of receiving an ink during the printing process and a hydrophilic non-image area of receiving a fountain solution. The lithographic printing is a printing method using a lithographic printing plate having a lipophilic image area as the ink-receiving part and a hydrophilic non-image area as the fountain solution-receiving part (ink non-receiving part), where the ink adhesion to the surface of the lithographic printing plate is caused to differ by taking advantage of mutual repulsion between water and oily ink and after inking only the image area, the ink is transferred to a material on which an image is printed, such as paper. For producing this lithographic printing plate, a lithographic printing plate precursor (PS plate) comprising a hydrophilic support having provided thereon a lipophilic photosensitive resin layer (image recording layer) has been heretofore widely used. Usually, a lithographic printing plate is obtained by a plate-making method of exposing the lithographic printing plate precursor through an original image such as lith film and while leaving the image recording layer in the portion working out to an image area, dissolving and thereby removing the image recording layer in other unnecessary portions with an alkaline developer or an organic solvent to reveal the hydrophilic support surface.

In the plate-making process using a conventional lithographic printing plate precursor, a step of dissolving and thereby removing the image recording layer in the unnecessary portion with an alkaline developer or the like must be provided after exposure. As one problem to be solved, it is demanded to dispense with or simplify such additive wet processing. Particularly, the treatment of waste solutions discharged along with the wet processing is recently a great concern to the entire industrial world in view of consideration for global environment, and the demand for solving this problem is becoming stronger.

In this regard, as in JP-A-2001-277742 (the term "JP-A" as used herein means an "unexamined published Japanese patent application"), a method called on-press development has been proposed, where an image recording layer enabling to remove the unnecessary portion of a lithographic printing plate precursor during a normal printing process is used and after exposure, the non-image area is removed on a printing press to obtain a lithographic printing plate. According to this method, digitized image information is carried on a highly convergent radiant ray such as laser light in compliance with a digitization technique of electronically processing, storing and outputting image information by a computer, and the lithographic printing plate precursor is scan-exposed by the light. After exposure, the non-image area is removed on a printing press by using a printing ink, a fountain solution or both thereof, whereby a lithographic printing plate can be obtained and the development step of a lithographic printing plate, which is an indispensable step in the conventional printing plate-making industry, can be dispensed with. As a result, the plate-making operation becomes a work in a completely dry (not using a liquid) environment and the load in view of environment and work operation can be reduced.

EP 0 336 400 describes a developer for developing a dry presensitized plate for use in making lithographic printing plates in which a silicone layer rubber layer serves as ink repellent layer and which requires no dampening water during printing operation.

GB 1 515 174 relates to a process for removing non-image areas of photo hardened layers present on printing plates and for preserving the plates.

GB 2 046 474 describes a retouching agent for lithographic printing plates which can be used for erasing a portion of the image area of a lithographic printing plate.

Incidentally, in the present invention, unless otherwise indicated, the "development step" indicates a step where using an apparatus except for a printing press, the image recording layer in the unexposed portion of a lithographic printing plate precursor is removed through contact with a liquid (usually an alkaline developer) to reveal the hydrophilic support surface, and the "on-press development" indicates a method or step where using a printing press, the image recording layer in the unexposed portion of a lithographic printing plate precursor is removed through contact with a liquid (usually a printing ink and/or a fountain solution) to reveal the hydrophilic support surface.

The on-press developed printing plate has the above-described advantages, but because of having a step of removing the image recording layer by using a printing press, there is a problem that for preventing coloring contamination by ink, only a minimum amount of a colorant can be used in the image recording layer. In general, an operation of inspecting or identifying the image on the printing plate to check, for example, whether an intended image is recorded on the printing plate or what color ink is assigned to the plate, is performed as a pre-step before loading a printing plate on a printing press. In the case of a normal lithographic printing plate precursor involving a development step, the image can be easily confirmed after plate-making (after development) or before printing (before loading the printing plate on a printing press) by adding a colorant to the image recording layer. However, in the case of an on-press development type or non-processing (non-development) type lithographic printing plate precursor involving no development step before printing, since only a minimum amount of a colorant can be used in the image recording layer, the image can be hardly confirmed at the stage of loading the printing plate on a printing press and the plate cannot be identified, as a result, an operation error sometimes occurs. In particular, it is important in the printing operation that whether or not registry guides (register marks) as the eyemark for registration in multicolor printing are clearly drawn can be or cannot be recognized. A first object of the present invention is to solve this problem.

Also, in the printing industry, whether proper exposure or development is performed is generally confirmed at regular intervals by using a halftone dot area meter or a densitometer. In the case of the measured value deviating from the adequate value, the halftone dot area or density in the final output is adjusted by maneuvering the input signal of the exposure apparatus. This work, which is called a calibration work, is an important operation periodically performed so as to maintain a proper image quality at all times. As for the confirmation of the image quality, various methods are known but in general, a method of outputting an image having a given halftone dot area percentage by an exposure machine, performing development, digitizing the obtained halftone dot by using a halftone dot area percentage meter or a densitometer, and when the value deviates, fluctuating the exposure signal to approximate the expected numerical value is employed. The densitometer used here usually has detection sensitivity in the visible region (from 400 to 700 nm), but in the case of a lithographic printing plate having no absorption in this wavelength region (for example, an infrared-sensitive printing plate of JP-A-2001-277742), the image cannot be detected at all and there is a problem that the calibration work cannot be performed. Another object of the present invention is to provide a method for controlling the image quality of a lithographic printing plate having substantially no absorption in the visible region.

### Summary of the Invention

The present invention relates to a method for staining an on-press developed printing plate free from ink contamination, that is, having substantially no absorption in the visible region, and a processing method therefor.

As a result of intensive studies made by taking note of the constituent components of an image recording material for the image recording layer of a lithographic printing plate precursor and the components for staining those constituent components, the present inventors have found that when a compound capable of interacting with a basic coloring matter is added to the image recording layer and brought into contact with an aqueous solution containing a basic coloring matter, the above-described objects can be obtained. The present invention has been accomplished based on this finding.

The present invention is as defined in the claims.

### Detailed Description of the Invention

### [Aqueous Solution Containing Basic Coloring Matter]

The aqueous solution for staining a lithographic printing plate precursor used in the present invention is described in detail below.

The aqueous solution for use in the present invention indispensably contains a basic coloring matter. The basic coloring matter as used herein means a coloring matter positively charged in the aqueous solution and specifically indicates a basic dye, a basic pigment, a color material coated with a basic or cationic resin, a color material coated with a basic or cationic surfactant, or the like.

Examples of the basic dye and pigment include:
C.I. Basic Yellow 1, 2, 11, 13, 14, 15, 19, 21, 23, 24, 25, 28, 29, 32, 36,40, 41, 45, 49, 51, 53, 63, 64, 65, 67, 70, 73, 77, 87, 91,
C.I. Basic Red 2, 12, 13, 14, 15, 18, 22, 23, 24, 27, 29, 35, 36, 38, 39, 46, 49, 51, 52, 54, 59, 68, 69, 70, 73, 78, 82, 102, 104, 109, 112,
C.I. Basic Blue 1, 3, 5, 7, 9, 21, 22, 26, 35, 41, 45, 47, 54, 62, 65, 66, 67, 69, 75, 77, 78, 89, 92, 93,105, 117, 120, 122, 124, 129, 137, 141,147, 155, and
C.I. Basic Black 2, 8.

Among these dyes, Crystal Violet and Methylene Blue are particularly preferred.

As for the basic or cationic resin, a commercially available product may be used and specific examples thereof include PAS-A-1, PAS-A-5, PAS-A-120L, PAS-A-120S, PSA-J-81, PAS-880, PAS-92 (diallyldimethyl ammonium salt-based copolymerization product), PAS-H-5L, PAS-H-10L and PAS-M-1 (diallyldimethyl ammonium salt-based polymerization product) (all produced by Nitto Boseki Co., Ltd.); PAA-HCl-3L, PAA-HCl-10L (polyallylamine hydrochloride) and PAA-10C (polyallylamine) (all produced by Nitto Boseki Co., Ltd.); Q-101 (polyamine-based), Q-311 (polyamine-based) and Q-501 (polyamine-based) (all produced by HYMO Co., Ltd.); and ACCOFLOC C567, C573, C577 and C581 (polyamine-based) (all produced by Mitsui SciTech K.K.)

Examples of the basic or cationic surfactant include an alkylamine salt, a dialkylamine salt, an aliphatic amine salt, a benzalkonium salt, a quaternary ammonium salt, an alkylpyridinium salt, an imidazolinium salt, a sulfonium salt and an onium salt.

As for the coloring matter oriented in such a basic or cationic resin (activator) and coated therewith, examples of the acid dye and food dye which can be used include:
C.I. Acid Yellow 17,23,42,44,79 and 142,
C.I. Acid Red 1, 8. 13, 14, 18, 26, 27, 35, 37, 42, 52, 82, 87, 89, 92, 97, 106, 111, 114, 115, 134, 186,249,254 and 289,
C.I. Acid Blue 9, 29, 45, 92 and 249,
C.I. Acid Black 1, 2, 7, 24, 26 and 94,
C.I. Food Yellow 3 and 4,
C.I. Food Red 7, 9 and 14, and
C.I. Food black 1 and 2.

Examples of the direct dye which can be used include:
C.I. Direct Yellow, 1, 12,24,26,33,44, 50, 86,120,132,142 and 144,
C.I. Direct Red 1, 4, 9, 13, 17, 20, 28, 31, 39, 80, 81, 83, 89, 225 and 227,
C.I. Direct Orange 26, 29, 62 and 102,
C.I. Direct Blue 1, 2, 6, 15, 22, 25, 71, 76, 79, 86, 87, 90, 98, 163, 165, 199 and 202, and
C.L Direct Black 19, 22, 32, 38, 51, 56, 71, 74, 75, 77, 154, 168 and 171.

Examples of the reactive dye include:
C.I. Reactive Black 3, 4, 7, 11, 12 and 17,
C.I. Reactive Yellow, 1, 5,11, 13, 14, 20, 21, 22, 25, 40, 47, 51, 55, 65 and 67,
C.I. Reactive Red 1, 14, 17, 25, 26, 32, 37, 44, 46, 55, 60, 66, 74, 79, 96 and 97, and
C.I. Reactive Blue 1, 2, 7, 14, 15, 23, 32, 35, 38, 41, 63, 80 and 95.

As for the pigment oriented in the basic resin (activator) and coated therewith, examples of the inorganic pigment which can be used include titanium oxide, iron oxide, calcium carbonate, barium sulfate, ammonium hydroxide, barium yellow, cadmium red, chromium yellow, and carbon black produced by a known method such as contact method, furnace method and thermal method.

Examples of the organic pigment which can be used include an azo pigment (including an azo lake, an insoluble azo pigment, a condensed azo pigment and a chelate azo pigment), a polycyclic pigment (e.g., phthalocyanine pigment, perylene pigment, perinone pigment, anthraquinone pigment, quinacridone pigment, dioxazine pigment, indigo pigment, thioindigo pigment, isoindolinone pigment, quinophthalone pigment), a dye chelate (e.g., basic dye-type chelate, acid dye-type chelate), a nitro pigment, a nitroso pigment, and aniline black.

The amount of the basic coloring matter added to the aqueous solution is preferably from 0.001 to 5 wt%, more preferably from 0.01 to 1 wt%. Within such a range, a good dyeing density can be obtained. If the amount added is less than this range, the staining effect is low, whereas if it exceeds the above-described range, solubilization in the aqueous solution becomes difficult and a uniform staining effect cannot be obtained.

Other materials added to the aqueous solution are described below.

In the aqueous solution, other than the basic coloring matter, for example, an organic solvent, a surfactant, a defoaming agent, an antiseptic, a wetting agent, a hard water softening agent, a water-soluble polymer, a pH adjusting agent such as acid and alkali, and a pH buffer may be added. The organic solvent, surfactant and hard water softening agent are used mainly for the purpose of accelerating the removal of unexposed area of the image recording layer. The pH adjusting agent (e.g., acid, alkali) and pH buffer are used mainly for the purpose of maintaining the stability of colorant, the immobilization stability of colorant, and the stability of color hue. The water-soluble polymer is used mainly for the purpose of maintaining the hydrophilicity of the non-image area and preventing so-called printing contamination when printing is performed by a printing press after the lithographic printing plate is stained.

The organic solvent indicates a compound having a solubility in water of 10 mass% or less at ordinary temperature (20°C). (In this specification, mass ratio is equal to weight ratio.) In many cases, such a compound has a property of penetrating into the unexposed area (non-image area) of the photosensitive composition layer. Examples of the organic solvent include, but are not limited to, a carboxylic acid ester such as ethyl acetate, propyl acetate, butyl acetate, amine acetate, benzyl acetate, ethylene glycol monobutyl acetate, butyl lactate and butyl levulinate; ketones such as ethyl butyl ketone, methyl isobutyl ketone and cyclohexanone; alcohols such as ethylene glycol monobutyl ether, ethylene glycol benzyl ether, ethylene glycol monophenyl ether, benzyl alcohol, methylphenylcarbinol, n-amyl alcohol and methylamyl alcohol; an alkyl-substituted aromatic hydrocarbon such as xylene; and a halogenated hydrocarbon such as methylene dichloride, ethylene dichloride and monochlorobenzene. One of these hydrophobic compounds may be used alone, or two or more species thereof may be used in combination. Among these hydrophobic compounds, ethylene glycol monophenyl ether and benzyl alcohol are particularly effective. The content of such a compound in the processing solution is approximately from 0 to 10 mass%, and when the content is from 0.5 to 5 mass%, more preferred results are obtained.

The surfactant includes, for example, an anionic surfactant and/or a nonionic surfactant. Examples of the anionic surfactant include fatty acid salts, abietates, hydroxyalkanesulfonates, alkanesulfonates, dialkylsulfosuccinates, linear alkylbenzenesulfonates, branched alkylbenzenesulfonates, alkylnaphthalenesulfonates, alkylphenoxypolyoxyethylenepropylsulfonates, polyoxyethylenealkylsulfophenyl ether salts, N-methyl-N-oleyltaurine sodium salts, N-alkylsulfosuccinic acid monoamide disodium salts, petroleum sulfonates, sulfated castor oil, sulfated beef tallow oil, sulfuric ester salts of fatty acid alkyl ester, alkylsulfuric ester salts, polyoxyethylene alkyl ether sulfuric ester salts, fatty acid monoglyceride sulfuric ester salts, polyoxyethylene alkylphenyl ether sulfuric ester salts, polyoxyethylene styrylphenyl ether sulfuric ester salts, alkylphosphoric ester salts, polyoxyethylene alkyl ether phosphoric ester salts, polyoxyethylene alkylphenyl ether phosphoric ester salts, partially saponified styrene-maleic anhydride copolymers, partially saponified olefinmaleic anhydride copolymers, and naphthalenesulfonate formalin condensates. Among these, dialkylsulfosuccinates, alkylsulfuric ester salts and alkylnaphthalenesulfonates are preferred.

Examples of the nonionic surfactant include polyoxyethylene alkyl ethers, polyoxyethylene alkylphenyl ethers, polyoxyethylene polystyrylphenyl ether, glycerin fatty acid partial esters, sorbitan fatty acid partial esters, pentaerythritol fatty acid partial esters, propylene glycol monofatty acid ester, sucrose fatty acid partial ester, polyoxyethylene sorbitan fatty acid partial esters, polyoxyethylene sorbitol fatty acid partial esters, polyethylene glycol fatty acid esters, polyglycerin fatty acid partial esters, polyoxyethylene glycerin fatty acid partial esters, fatty acid diethanolamides, N,N-bis-2-hydroxyalkylamines, polyoxyethylene alkylamine, triethanolamine fatty acid ester, and trialkylamine oxide. Among these, preferred are polyoxyethylene alkylphenyl ethers and polyoxyethylene-polyoxypropylene block copolymers. In addition, anionic and nonionic surfactants such as an oxyethylene adduct of acetylene glycol-based or acetylene alcohol-based surfactant, a fluorine-containing surfactant, and a silicon-containing surfactant, may also be used. These surfactants may be used in combination of two or more thereof. For example, a combination use of two or more anionic surfactants different from each other, or a combination use of an anionic surfactant with a nonionic surfactant is preferred. An appropriate surfactant is preferably selected from these compounds and used by taking into consideration the effect on the environment. The amount of the surfactant used is not particularly limited but is preferably from 0.01 to 20 mass% based on the entire solid content weight.

Examples of the water-soluble polymer compound include gum arabic, dextrin, a cellulose derivative (e.g., carboxymethyl cellulose, carboxyethyl cellulose, methyl cellulose) and a denatured product thereof, pullulan, polyvinyl alcohol and a derivative thereof, polyvinylpyrrolidone, polyacrylamide and a copolymer thereof, a vinyl methyl ether/maleic anhydride copolymer, a vinyl acetate/maleic anhydride copolymer, and a styrene/maleic anhydride copolymer. Among these, gum arabic, dextrin and carboxymethyl cellulose are preferred. These compounds may be used in combination of one or more thereof. The content of the compound is preferably from 0.1 to 20 mass%, more preferably from 0.3 to 10 mass%, based on the entire solid content weight.

Examples of the wetting agent which can be suitably used include ethylene glycol, propylene glycol, triethylene glycol, butylene glycol, hexylene glycol, diethylene glycol, dipropylene glycol, glycerin, trimethylolpropane and diglycerol. One of these wetting agents may be used alone or two or more species thereof may be used in combination. In general, the wetting agent is used in an amount of 0.1 to 5 mass% based on the entire solid content weight.

Examples of the antiseptic which can be preferably used include phenol and a derivative thereof, formalin, an imidazole derivative, sodium dehydroacetate, a 4-isothiazolin-3-one derivative, benzoisothiazolin-3-one, a benzotriazole derivative, an amidine guanidine derivative, quaternary ammonium salts, a derivative of pyridine, quinoline or guanidine, diazine, a tirazole derivative, oxazole, an oxazine derivative, and a nitrobromoalcohol-based antiseptic such as 2-bromo-2-nitropropane-1,3-diol, 1,1-dibromo-1-nitro-2-ethanol and 1,1-dibromo-1-nitro-2-propanol. The antiseptic is preferably added in an amount sufficiently large to stably exert the effect against bacteria, fungi, yeast and the like. The amount varies depending on the kind of the bacteria, fungi or yeast but is preferably from 0.01 to 4 mass%. Also, two or more kinds of antiseptics are preferably used in combination so as to exert the effect against various fungi or bacteria.

Examples of the hard water softening agent include organic phosphonic acids and phosphonoalkanetricarboxylic acids such as ethylenediaminetetraacetic acid, a potassium salt thereof and a sodium salt thereof; diethylenetriaminepentaacetic acid, a potassium salt thereof and a sodium salt thereof; triethylenetetraminehexaacetic acid, a potassium salt thereof and a sodium salt thereof; hydroxyethylethylenediaminetriacetic acid, a potassium salt thereof and a sodium salt thereof; nitrilotriacetic acid and a sodium salt thereof; 1-hydroxyethane-1,1-diphosphonic acid, a potassium salt thereof and a sodium salt thereof; and aminotri(methylenephosphonic acid), a potassium salt thereof and a sodium salt thereof. In these chelating agents, an organic amine salt may also be effectively used in place of the sodium salt or potassium salt. From these, a chelating agent which can be stably present in the desensitizing composition and does not inhibit the printing property is selected. The amount added thereof is suitably from 0.001 to 1.0 mass% based.

As for the defoaming agent, a silicon-containing self-emulsifying or emulsifying surfactant in general or a nonionic compound having an HLB of 5 or less may be used. A silicon defoaming agent is preferred and this may be either emulsion-dispersing type or solubilizing type. The content of the defoaming agent is most preferably from 0.001 to 1.0 mass%.

### [Processing Method of Lithographic Printing Plate Precursor with Aqueous Solution Containing Basic Coloring Matter]

In the present invention, the imagewise exposed lithographic printing plate precursor is brought into contact with an aqueous solution containing the above-described basic coloring matter to stain the image area.

By virtue of this staining, the plate inspection and image quality control are facilitated. Furthermore, the inking property at the start of printing is enhanced and the paper loss can be reduced.

Specific examples of the processing include manual development, dipping development and processing by an automatic developing machine. In the case of manual development, a sponge or absorbent cotton is well impregnated with the aqueous solution, and the entire plate surface is rubbed therewith to effect the development and after the completion of development, thoroughly washed with water. In the case of dipping development, the lithographic printing plate precursor is dipped in a vat or deep tank containing the aqueous solution for approximately from 10 to 180 seconds and then thoroughly washed with water while rubbing it with an absorbent cotton, a sponge or the like. As for the automatic developing machine, an automatic developing machine conventionally used for PS plates can be employed. For example, any of a system where the developer in the development tank is pumped up and sprayed from a spray nozzle to perform the development, a system where a printing plate is dipped in a developer tank filled with a developer while conveying the plate by an in-liquid guide roll or the like and thereby processed, and a so-called disposable system where a substantially unused developer in a necessary amount is supplied every each plate to perform the processing, can be applied. In any system, it is more preferred to have a rubbing mechanism using a brush or a morton.

### [Plate Inspection Method and Image Quality Control Method]

In the present invention of performing the above-described processing with an aqueous solution containing a basic coloring matter, the plate inspection is preferably performed by visualizing the image through (1) a step of imagewise exposing the lithographic printing plate precursor, (2) a step of bringing it into contact with an aqueous solution containing a basic coloring matter to stain the exposed portion of the image recording layer, and (3) a step of drying the plate.

Also, the image quality is preferably controlled by performing the measurement in (4) a step of measuring the halftone dot area or density of the image by a halftone dot area meter or a densitometer, after (3) the step of drying the plate.

The staining of the image area of the image recording layer and the removal of the non-image area is simultaneously performed using the aqueous solution of the present invention.

### [Lithographic Printing Plate Precursor]

The lithographic printing plate precursor used in the present invention has, on a support, an image recording layer containing a compound which interacts with a basic coloring matter and being removal by a printing ink, a fountain solution or both thereof. These constituent elements of the lithographic printing plate precursor are described in detail below.

### (Image Recording Layer)

The image recording layer used in the present invention contains a compound capable of interacting with a basic coloring matter and can be removed by a printing ink, a fountain solution or both thereof. Also, the image recording layer used in the present invention may contain an element for forming a printing image.

### <Compound which Interacts with Basic Coloring Matter>

In the present invention, a compound which interacts with a basic coloring matter means a compound having a function of immobilizing a basic coloring matter, and the interaction for immobilization may be an electrostatic interaction or other interactions. More specifically, the compound which interacts with a basic coloring matter includes a compound of undergoing salt dissociation in the aqueous solution and thereby being negatively charged. The compound which immobilizes a basic coloring matter is preferably a compound forming an insoluble salt with the basic coloring matter, a polymer compound having a molecular weight of 1,000 or more, or a particle having a particle diameter of 5 nm or more. Examples of such a compound include an inorganic layered compound, an inorganic fine particle, and a polymer compound containing an anionic group such as carboxyl group, sulfonic acid group and phosphoric acid group. Among these, an inorganic layered compound and an inorganic fine particle are preferred.

The inorganic layered compound is preferably a compound having an aspect ratio of 20 or more. In the image recording layer, the layered compound when laminated and distributed in parallel to the support produces an effect of increasing the cohesive property of the image recording layer, whereby the amount of the basic coloring matter adsorbed per unit area can be increased.

The layered compound is a particle having a thin plate-like shape, and examples thereof include a mica family represented by the following formula:

A(B, C)₂₋₅D₄O₁₀(OH, F, O)₂

[wherein A is any one of Li, K, Na, Ca, Mg and organic cation, B and C each is any one of Fe(II), Fe(III), Mn, Al, Mg and V, and D is Si or Al], such as natural mica and synthetic mica; talc represented by the formula: 3MgO·4SiO·H₂O; taeniolite; montmorillonite; saponite; hectorite; and zirconium phosphate.

Examples of the natural mica include muscovite, paragonite, phlogopite, biotite and lepidolite, and examples of the synthetic mica include a non-swelling mica such as fluorophlogopite KMg₃(AlSi₃O₁₀)F₂ and potassium tetrasilicic mica KMg_{2.5}(Si₄O₁₀)₂, and a swelling mica such as Na tetrasilicic mica NaMg_{2.5}(Si₄O₁₀)F₂, Na or Li taeniolite (Na, Li)Mg₂Li(Si₄O₁₀)F₂ and montmorillonite-based Na or Li hectorite (Na, Li)_{1/8}Mg_{2/5}Li_{1/8}(Si₄O₁₀)F₂. Furthermore, synthetic smectite is also useful.

Among these layered compounds, a fluorine-based swelling mica, which is a synthetic inorganic layered compound, is useful. More specifically, this swelling synthetic mica and swelling clay minerals such as montmorillonite, saponite, hectorite and bentonite have a laminate structure comprising a unit crystal lattice layer having a thickness of approximately from 10 to 15 Å, and the extent of the intra-lattice metallic atom substitution is significantly larger than that of other clay minerals. As a result, the lattice layer causes shortage in positive charge, and a cation such as Li⁺, Na⁺, Ca²⁺, Mg²⁺ and organic cation is adsorbed between layers to compensate the shortage. Such an inorganic layered compound swells with water and when a shearing force is applied in this state, cleavage readily occurs to form a stable sol in water. This tendency is strong in bentonite and swelling synthetic mica.

As for the shape of the layered compound, from the standpoint of increasing the adsorbed amount, a smaller thickness is more preferred and as long as the smoothness of the coated surface or the transparency to actinic rays is not impaired, a larger plane size is more preferred. Accordingly, the aspect ratio is 20 or more, preferably 100 or more, more preferably 200 or more. Incidentally, the aspect ratio is a ratio of thickness to long diameter of a particle and can be measured, for example, from a projection view by a microphotograph of particles. As the aspect ratio is larger, the effect obtained is higher.

As for the particle diameter of the layered compound, the average diameter is from 1 to 20 µm, preferably from 1 to 10 µm, more preferably from 2 to 5 µm. If the particle diameter is less than 1 µm, the permeation of oxygen or moisture cannot be satisfactorily suppressed and this gives rise to failure in exerting a sufficiently high effect, whereas if it exceeds 20 µm, the dispersion stability in the coating solution is insufficient and there arises a problem that stable coating cannot be performed. Also, the average thickness of the particle is 0.1 µm or less, preferably 0.05 µm or less, more preferably 0.01 µm or less. For example, the swelling synthetic mica as a representative compound of the inorganic layered compound has a thickness of 1 to 50 nm and a plane size of approximately from 1 to 20 µm.

When an inorganic layered compound particle having such a large aspect ratio is incorporated into the image recording layer, the layered compound is laminated and distributed in parallel to the support in the image recording layer and produces an effect of increasing the cohesive property of the image recording layer, whereby the amount of the basic coloring matter adsorbed per unit area can be increased.

The content of the layered compound in the image recording layer is preferably from 0.1 to 50 mass%, more preferably from 0.3 to 30 mass%, and most preferably from 1 to 10 mass%. Even in the case of using a plurality of layered compound species in combination, the total amount of these layered compounds is preferably in the above-described content range.

An example of the dispersion method in general for the layered compound is described below. First, from 5 to 10 parts by mass of a swelling layered compound described above as a preferred layered compound is added to 100 parts by mass of water and after well wetting and swelling with water, dispersed using a disperser. Examples of the disperser used here include various mills of effecting dispersion by directly applying a mechanical force, a high-speed stirring-type disperser having a large shearing force, and a disperser of giving a high-intensity ultrasonic energy. Specific examples thereof include a ball mill, a sand grinder mill, a visco-mill, a colloid mill, a homogenizer, a dissolver, a polytron, a homomixer, a homoblender, a KD mill, a jet agitator, a capillary-type emulsifier, a liquid siren, an electromagnetic strain-type ultrasonic generator, and an emulsifier with Paulman whistle. A dispersion containing from 5 to 10 mass% of the inorganic layered compound dispersed by the above-described method is in a highly viscous or gelled state, and its storage stability is remarkably good. At the time of preparing a coating solution by using this dispersion, the dispersion is preferably diluted with water and thoroughly stirred before blending with the coating solution.

Examples of the inorganic fine particle include silica, silicate, magnesium oxide, titanium oxide and magnesium carbonate. The average particle diameter of the inorganic fine particle is preferably from 5 nm to 10 µm, more preferably from 100 nm to 5 m. Within this range, the inorganic particle can be stably dispersed in the image recording layer, as a result, the image recording layer can maintain sufficiently high film strength and the non-image area formed can have excellent hydrophilicity. The content of the inorganic fine particle is preferably 20 mass% or less, more preferably 10 mass% or less, based on the entire solid content in the image recording layer.

### <Printing Image-Forming Element>

In the present invention, the conditions for the printing image-forming element used in the image recording layer are not particularly limited, and known printing image-forming elements may be used. An element utilizing a polymerization reaction, which is one of preferred printing image-forming elements, is described below. Incidentally, in the present invention, a layer containing an actinic ray absorbent, a polymerization initiator, a polymerizable compound, a binder polymer and the like is defined as an image forming layer and differentiated from a protective layer provided on the image forming layer and an undercoat layer provided under the image forming layer. The term "image recording layer" as used in the present invention means, when a protective layer and an undercoat layer are provided, a layer including all of these layers.

In the element utilizing a polymerization reaction, a printing image can be formed by a construction mainly comprising (A) an actinic ray absorbent, (B) a polymerization initiator, (C) a polymerizable compound and (D) a binder polymer. Also, the image forming layer utilizing a polymerization reaction may contain known additives other than these, if desired.

This lithographic printing plate precursor utilizing a polymerization reaction has a property, for example, that the exposed area of the image forming layer is cured upon irradiation with infrared rays to form a hydrophobic (lipophilic) region and the unexposed area of the image forming layer is swiftly removed from the support by a fountain solution, an ink or an emulsified product of fountain solution and ink. That is, the above-described image forming layer is an image forming layer removable with a printing ink and/or a fountain solution.

### <(A) Actinic Ray Absorbent>

In the case of using a laser capable of emitting an infrared ray of 760 to 1,200 nm as the light source to form an image on the lithographic printing plate precursor of the present invention, it is usually preferred to use an infrared absorbent. The infrared absorbent has a function of converting the absorbed infrared ray into heat and a function of being excited by the infrared ray to cause electron transfer/energy transfer to a radical polymerization initiator (radical generator) which is described later. The infrared absorbent used in the present invention is a dye or pigment having an absorption maximum in the wavelength region of 760 to 1,200 nm.

Also, from the standpoint of preventing ink contamination, the infrared absorbent preferably has substantially no absorption maximum in the wavelength region of 400 to 700 nm. Specifically, the absorbance at the absorption maximum in the wavelength region of 400 to 700 nm of the image forming layer is preferably 0.1 or less (in terms of reflection density of the lithographic printing plate precursor).

As for the dye, commercially available dyes and known dyes described in publications such as Senryo Binran (Handbook of Dyes), compiled by Yuki Gosei Kagaku Kyokai (1970) may be used. Specific examples thereof include dyes such as azo dye, metal complex salt azo dye, pyrazolone azo dye, naphthoquinone dye, anthraquinone dye, phthalocyanine dye, carbonium dye, quinoneimine dye, methine dye, cyanine dye, squarylium coloring matter, pyrylium salt and metal thiolate complex.

Preferred examples of the dye include cyanine dyes described in JP-A-58-125246, JP-A-59-84356 and JP-A-60-78787, methine dyes described in JP-A-58-173696, JP-A-58-181690 and JP-A-58-194595, naphthoquinone dyes described in JP-A-58-112793, JP-A-58-224793, JP-A-59-48187, JP-A-59-73996, JP-A-60-52940 and JP-A-60-63744, squarylium coloring matters described in JP-A-58-112792, and cyanine dyes described in British Patent 434,875.

Also, near infrared absorbing sensitizers described in U.S. Patent 5,156,938 may be suitably used. Furthermore, substituted arylbenzo(thio)pyrylium salts described in U.S. Patent 3,881,924, trimethinethiapyrylium salts described in JP-A-57-142645, pyrylium-based compounds described in JP-A-58-181051, JP-A-58-220143, JP-A-59-41363, JP-A-59-84248, JP-59-84249, JP-A-59-146063 and JP-A-59-146061, cyanine coloring matters described in JP-A-59-216146, pentamethinethiopyrylium salts described in U.S. Patent 4,283,475, and pyrylium compounds described in JP-B-5-13514 (the term "JP-B" as used herein means an "examined Japanese patent publication") and JP-B-5-19702 may also be preferably used. Other preferred examples of the dye include near infrared absorbing dyes represented by formulae (I) and (II) of U.S. Patent 4,756,993.

Other preferred examples of the infrared absorbing coloring matter for use in the present invention include specific indolenine cyanine coloring matters described in JP-A-2002-278057, such as those set forth below.

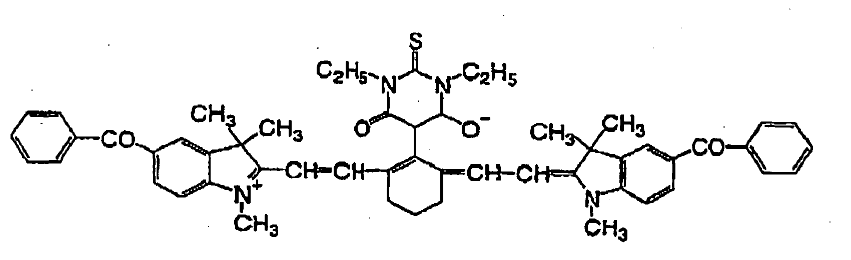

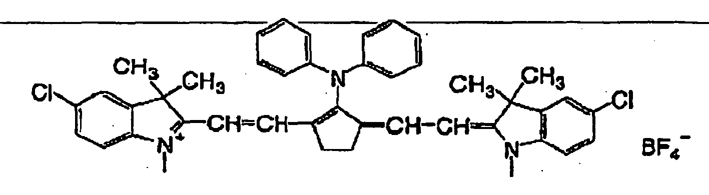

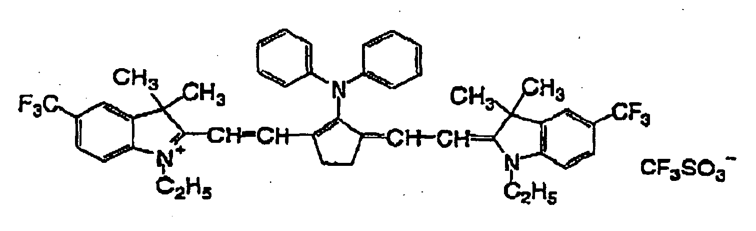

Among these dyes, preferred are a cyanine coloring matter, a squarylium coloring matter, a pyrylium salt, a nickel thiolate complex and an indolenine cyanine coloring matter, more preferred are a cyanine coloring matter and an indolenine cyanine coloring matter. One particularly preferred example is a cyanine coloring matter represented by the following formula (I):

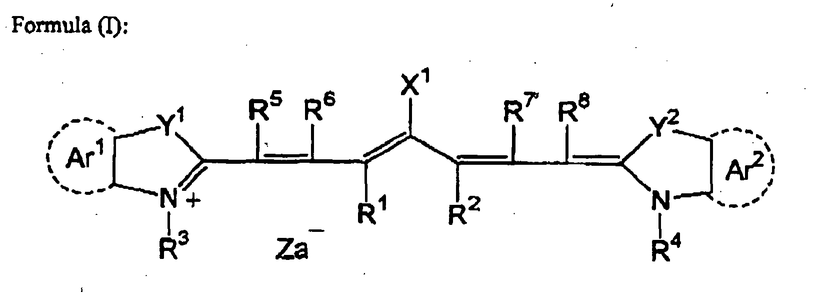

In formula (I), X¹ represents a hydrogen atom, a halogen atom, -NPh₂, X²-L¹ or a group shown below:

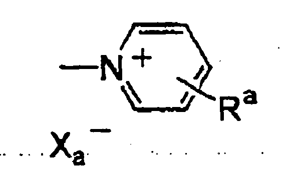

In formula (I), X² represents an oxygen atom, a nitrogen atom or a sulfur atom, L¹ represents a hydrocarbon group having from 1 to 12 carbon atoms, an aromatic ring having a heteroatom, or a hydrocarbon group having from 1 to 12 carbon atoms and containing a heteroatom (the heteroatom as used herein indicates N, S, O, a halogen atom or Se), Xa⁻ has the same definition as Za⁻ described later, and R^{a} represents a substituent selected from a hydrogen atom, an alkyl group, an aryl group, a substituted or unsubstituted amino group and a halogen atom. Ph represents a phenyl group.

In formula (I), R¹ and R² each independently represents a hydrocarbon group having from 1 to 12 carbon atoms. In view of storage stability of the coating solution for recording layer, R¹ and R² each is preferably a hydrocarbon group having 2 or more carbon atoms, and R¹ and R² are more preferably combined with each other to form a 5-or 6-membered ring.

Ar¹ and Ar² may be the same or different and each represents an aromatic hydrocarbon group which may have a substituent. Preferred examples of the aromatic hydrocarbon group include a benzene ring and a naphthalene ring. Preferred examples of the substituent include a hydrocarbon group having 12 or less carbon atoms, a halogen atom and an alkoxy group having 12 or less carbon atoms. Y¹ and Y² may be the same or different and each represents a sulfur atom or a dialkylmethylene group having 12 or less carbon atoms. R³ and R⁴ may be the same or different and each represents a hydrocarbon group having 20 or less carbon atoms, which may have a substituent. Preferred examples of the substituent include an alkoxy group having 12 or less carbon atoms, a carboxyl group and a sulfo group. R⁵, R⁶, R⁷ and R⁸ may be the same or different and each represents a hydrogen atom or a hydrocarbon group having 12 or less carbon atoms and in view of availability of the raw material, preferably a hydrogen atom. Za⁻ represents a counter anion, but when the cyanine coloring matter represented by formula (I) has an anionic substituent in its structure and neutralization of electric charge is not necessary, Za⁻ is not required. In view of storage stability of the coating solution for recording layer, Za⁻ is preferably halogen ion, perchlorate ion, tetrafluoroborate ion, hexafluorophosphate ion or sulfonate ion, more preferably perchlorate ion, hexafluorophosphate ion or arylsulfonate ion.

Specific examples of the cyanine coloring matter represented by formula (I), which can be suitably used in the present invention, include those described in paragraphs [0017] to [0019] of JP-A-2001-133969.

Other preferred examples include specific indolenine cyanine coloring matters described in JP-A-2002-278057.

Furthermore, the infrared absorbent is preferably water-soluble but when water-insoluble, the infrared absorbent may be added by a method such as dispersion or dissolution in a mixed solvent.

As for the pigment used in the present invention, commercially available pigments and pigments described in Color Index (C.I.) Binran (C.I. Handbook), Saishin Ganryo Binran (Handbook of Latest Pigments), compiled by Nippon Ganryo Gijutsu Kyokai (1977), Saishin Ganryo Oyo Gijutsu (Latest Pigment Application Technology), CMC Shuppan (1986), and Insatsu Ink Gijutsu (Printing Ink Technology), CMC Shuppan (1984) can be used.

The kind of the pigment includes black pigment, yellow pigment, orange pigment, brown pigment, red pigment, violet pigment, blue pigment, green pigment, fluorescent pigment, metal powder pigment and other polymer bond coloring matters. Specific examples of the pigment which can be used include an insoluble azo pigment, an azo lake pigment, a condensed azo pigment, a chelate azo pigment, a phthalocyanine-based pigment, an anthraquinone-based pigment, a perylene- or perinone-based pigment, a thioindigo-based pigment, a quinacridone-based pigment, a dioxazine-based pigment, an isoindolinone-based pigment, a quinophthalone-based pigment, a dyed lake pigment, an azine pigment, a nitroso pigment, a nitro pigments, a natural pigment, a fluorescent pigment, an inorganic pigment and carbon black. Among these pigments, carbon black is preferred.

These pigments may or may not be surface-treated before use. Examples of the method for surface treatment include a method of coating the surface with resin or wax, a method of attaching a surfactant, and a method of binding a reactive substance (for example, a silane coupling agent, an epoxy compound or an isocyanate) to the pigment surface. These surface-treating methods are described in Kinzoku Sekken no Seishitsu to Oyo (Properties and Application of Metal Soap), Saiwai Shobo, Insatsu Ink Gijutsu (Printing Ink Technology), CMC Shuppan (1984), and Saishin Ganryo Oyo Gijutsu (Latest Pigment Application Technology), CMC Shuppan (1986).

The particle diameter of the pigment is preferably from 0.01 to 10 µm, more preferably from 0.05 to 1 µm, still more preferably from 0.1 to 1 µm. Within this range, good stability of the pigment dispersion in the coating solution for image forming layer and good uniformity of the image forming layer can be obtained. However, from the standpoint of preventing ink contamination, the pigment preferably has substantially no absorption maximum in the wavelength region of 400 to 700 nm. Specifically, the absorbance at the absorption maximum in the wavelength region of 400 to 700 nm is preferably 0.1 or less (in terms of reflection density of the lithographic printing plate precursor).

As for the method of dispersing the pigment, a known dispersion technique employed in the production of ink or toner may be used. Examples of the disperser include an ultrasonic disperser, a sand mill, an attritor, a pearl mill, a super-mill, a ball mill, an impeller, a disperser, a KD mill, a colloid mill, a dynatron, a three-roll mill and a pressure kneader. These are described in detail in Saishin Ganryo Oyo Gijutsu (Latest Pigment Application Technology), CMC Shuppan (1986).

The infrared absorbent may be added together with other components in the same layer or may be added to a layer provided separately but is added so that when a negative lithographic printing plate precursor is produced, the absorbance at the maximum absorption wavelength in the wavelength region of 760 to 1,200 nm of the image forming layer can be present in the range from 0.3 to 1.2, preferably from 0.4 to 1,1, as measured by the reflection measuring method. Within this range, a uniform polymerization reaction proceeds in the depth direction of the image forming layer and the image area can have good film strength and good adhesion to the support.

The absorbance of the image forming layer can be adjusted by controlling the amount of the infrared absorbent added to the image forming layer and the thickness of the image forming layer. The absorbance can be measured by an ordinary method. Examples of the measuring method include a method where an image forming layer having a thickness appropriately decided within the range of the dry coated amount necessary as a lithographic printing plate is formed on a reflective support such as aluminum and the reflection density is measured by an optical densitometer, and a method of measuring the absorbance by a spectrophotometer according to a reflection method using an integrating sphere.

### <(B) Radical Polymerization Initiator>

The radical polymerization initiator used in the present invention indicates a compound capable of generating a radical under light, heat or both energies and initiating and accelerating the polymerization of the compound having a polymerizable unsaturated group. Examples of the radical polymerization initiator (hereinafter sometimes simply referred to as a "polymerization initiator") which can be used in the present invention include known thermopolymerization initiators, a compound having a bond with small bond-dissociation energy, and a photopolymerization initiator. The compound capable of generating a radical, which is suitably used in the present invention, is a compound capable of generating a radical by the effect of heat energy and initiating and accelerating the polymerization of the compound having a polymerizable unsaturated group. As for the heat radical generator used in the present invention, a known polymerization initiator, a compound having a bond with small bond-dissociation energy, or the like may be appropriately selected and used. One radical-generating compound may be used alone or two or more species thereof may be used in combination.

Examples of the radical-generating compound include an organohalogen compound, a carbonyl compound, an organoperoxide compound, an azo-based compound, an azide compound, a metallocene compound, a hexaarylbiimidazole compound, an organoboric acid compound, a disulfonic acid compound, an oxime ester compound and an onium salt compound.

Specific examples of the organohalogen compound include the compounds described in Wakabayashi et al., Bull. Chem. Soc. Japan, 42, 2924 (1969), U.S. Patent 3,905,815, JP-B-46-4605, JP-A-48-36281, JP-A-55-32070, JP-A-60-239736, JP-A-61-169835, JP-A-61-169837, JP-A-62-58241, JP-A-62-212401, JP-A-63-70243, JP-A-63-298339, M.P. Hutt, Journal of Heterocyclic Chemistry, 1, No. 3 (1970). In particular, an oxazole compound substituted with a trihalomethyl group and an S-triazine compound are preferred.

An s-triazine derivative having bonded to the s-triazine ring thereof at least one mono-, di- or tri-halogen-substituted methyl group is more preferred, and specific examples thereof include 2,4,6-tris(monochloromethyl)-s-triazine, 2,4,6-tris(dichloromethyl)-s-triazine, 2,4,6-tris(trichloromethyl)-s-triazine, 2-methyl-4,6-bis-(trichloromethyl)-s-triazine, 2-n-propyl-4,6-bis(trichloromethyl)-s-triazine, 2-(α,α,β-trichloroethyl)-4,6-bis(trichoromethyl)-s-triazine, 2-phenyl-4,6-bis(trichloromethyl)-s-triazine, 2-(p-methoxyphenyl)-4,6-bis(trichloromethyl)-s-triazine, 2-(3,4-epoxyphenyl)-4,6-bis(trichloromethyl)-s-triazine, 2-(p-chlorophenyl)-4,6-bis(trichloromethyl)-s-triazine, 2-[1-(p-methoxyphenyl)-2,4-butadienyl]-4,6-bis(trichloromethyl)-s-triazine, 2-styryl-4,6-bis(trichloromethyl)-s-triazine, 2-(p-methoxystyryl)-4,6-bis(trichloromethyl)-s-triazine, 2-(p-i-propyloxystyryl)-4,6-bis(trichloromethyl)-s-triazine, 2-(p-tolyl)-4,6-bis(trichloromethyl)-s-triazine, 2-(4-methoxynaphmyl)-4,6-bis(trichlommethyl)-s-triazine, 2-phenylthio-4,6-bis(trichloromethyl)-s-triazine, 2-benzylthio-4,6-bis(trichloromethyl)-s-triazine, 2,4,6-tris(dibromomethyl)-s-triazine, 2,4,6-tris(tribromomethyl)-s-triazine, 2-methyl-4,6-bis(tribromomethyl)-s-triazine and 2-methoxy-4,6-bis(tribromomethyl)-s-triazine.

Examples of the carbonyl compound include a benzophenone derivative such as benzophenone, Michler's ketone, 2-methylbenzophenone, 3-methylbenzophenone, 4-methylbenzophenone, 2-chlorobenzophenone, 4-bromobenzophenone and 2-carboxybenzophenone; an acetophenone derivative such as 2,2-dimethoxy-2-phenylacetophenone, 2,2-diethoxyacetophenone, 1-hydroxycyclohexyl phenyl ketone, α-hydroxy-2-methylphenylpropanone, 1-hydroxy-1-methylethyl-(p-isopropylphenyl)ketone, 1-hydroxy-1-(p-dodecylphenyl)ketone, 2-methyl-(4'-(methylthio)phenyl)-2-morpholino-1-propanone and 1,1,1-trichloromethyl-(p-butylphenyl)ketone; a thioxantone derivative such as thioxantone, 2-ethylthioxanthone, 2-isopropylthioxanthone, 2-chlorothioxanthone, 2,4-dimethylthioxanthone, 2,4-diethylthioxanthone and 2,4-diisopropylthioxanthone; and a benzoic acid ester derivative such as ethyl p-dimethylaminobenzoate and ethyl p-diethylaminobenzoate.

As for the azo compound, for example, azo compounds described in JP-A-8-108621 can be used.

Examples of the organic peroxide compound include trimethylcyclohexanone peroxide, acetylacetone peroxide, 1,1-bis(tert-butylperoxy)-3,3,5-trimethylcyclohexane, 1,1-bis(tert-butylperoxy)cyclohexane, 2,2-bis(tert-butylperoxy)butane, tert-butyl hydroperoxide, cumene hydroperoxide, diisopropylbenzene hydroperoxide, 2,5-dimethylhexane-2,5-dihydroperoxide, 1,1,3,3-tetramethylbutyl hydroperoxide, tert-butylcumyl peroxide, dicumyl peroxide, 2,5-dimethyl-2,5-di(tert-butylperoxy)hexane, 2,5-oxanoyl peroxide, succinic peroxide, benzoyl peroxide, 2,4-dichlorobenzoyl peroxide, diisopropylperoxydicarbonate, di-2-ethylhexylperoxydicarbonate, di-2-ethoxyethylperoxydicarbonate, dimethoxyisopropylperoxycarbonate, di(3-methyl-3-methoxybutyl)peroxydicarbonate, tert-butyl peroxyacetate, tert-butyl peroxypivalate, tert-butyl peroxyneodecanoate, tert-butyl peroxyoctanoate, tert-butyl peroxylaurate, tertiary carbonate, 3,3',4,4'-tetra(tert-butylperoxycarbonyl)benzophenone, 3,3',4,4'-tetra(tert-hexylperoxycarbonyl)benzophenone, 3,3',4,4'-tetra(p-isopropylcumylperoxycarbonyl)benzophenone, carbonyl di(tert-butylperoxydihydrogendiphthalate) and carbonyl di(tert-hexylperoxydihydrogendiphthalate).

Examples of the metallocene compound include various titanocene compounds described in JP-A-59-152396, JP-A-61-151197, JP-A-63-41484, JP-A-2-249, JP-A-2-4705 and JP-A-5-83588, such as dicyclopentadienyl-Ti-bis-phenyl, dicyclopentadienyl-Ti-bis-2,6-difluorophen-1-yl, dicyclopentadienyl-Ti-bis-2,4-difluorophen-1-yl, dicyclopentadienyl-Ti-bis-2,4,6-trifluorophen-1-yl, dicyclopentadienyl-Ti-bis-2,3,5,6-tetrafluorophen-1-yl, dicyclopentadienyl-Ti-bis-2,3,4,5,6-pentafluorophen-1-yl, dimethylcyclopentadienyl-Ti-bis-2,6-difluorophen-1-yl, dimethylcyclopentadienyl-Ti-bis-2,4,6-trifluorophen-1-yl, dimethylcyclopentadienyl-Ti-bis-2,3,5,6-tetrafluorophen-1-yl and dimethylcyclopentadienyl-Ti-bis-2,3,4,5,6-pentafluorophen-1-yl, and iron-arene complexes described in JP-A-1-304453 and JP-A-1-152109.

Examples of the hexaarylbiimidazole compound include various compounds described in JP-B-6-29285 and U.S. Patents 3,479,185, 4,311,783 and 4,622,286, such as 2,2'-bis(o-chlorophenyl)-4,4',5,5'-tertaphenylbiimidazole, 2,2'-bis(o-bromophenyl)-4,4',5,5'-tetraphenylbiimidazole, 2,2'-bis(o,p-dichlorophenyl)-4,4',5,5'-tetraphenylbiimidazole, 2,2'-bis(o-chlorophenyl)-4,4',5,5'-tetra(m-methoxyphenyl)-biimidazole, 2,2'-bis(o,o'-dichlorophenyl)-4,4',5,5'-tetraphenylbiimidazole, 2,2'-bis(o-nitrophenyl)-4,4',5,5'-tetraphenylbiimidazole, 2,2'-bis(o-methylphenyl)-4,4',5,5'-tetraphenylbiimidazole and 2,2-'-bis(o-trifluorophenyl)-4,4',5,5-tetraphenylbiimidazole.

Examples of the organoborate compound include organoborate salts described in JP-A-62-143044, JP-A-62-150242, JP-A-9-188685, JP-A-9-188686, JP-A-9-188710, JP-A-2000-131837, JP-A-2002-107916, Japanese Patent No. 2764769, JP-A-2002-116539, and Martin Kunz, Rad Tech '98. Proceeding April 19-22, 1998, Chicago; organoboron sulfonium complexes and organoboron oxosulfonium complexes described in JP-A-6-157623, JP-A-6-175564 and JP-A-6-175561; organoboron iodonium complexes described in JP-A-6-175554 and JP-A-6-175553; organoboron phosphonium complexes described in JP-A-9-188710; and organoboron transition metal coordination complexes described in JP-A-6-348011, JP-A-7-128785, JP-A-7-140589, JP-A-7-306527 and JP-A-7-292014.

Examples of the disulfone compound include compounds described in JP-A-61-166544 and JP-A-2003-328465.

Examples of the oxime ester compound include compounds described in J.C.S. Perkin II, 1653-1660 (1979), J.C.S. Perkin II, 156-162 (1979), Journal of Photopolymer Science and Technology, 202-232 (1995), JP-A-2000-66385 and JP-A-2000-80068. Specific examples thereof include the compounds represented by the following structural formulae.

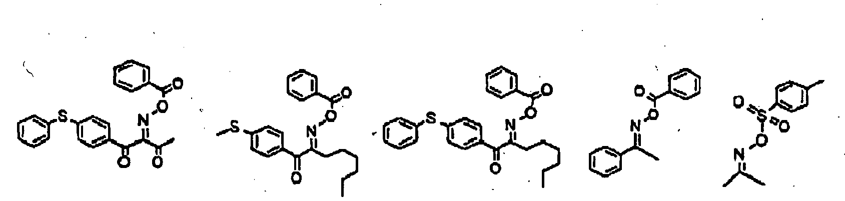

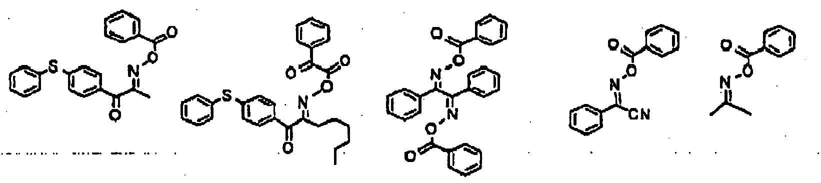

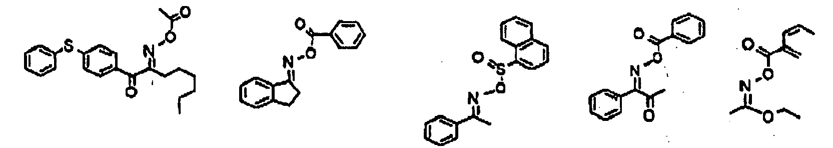

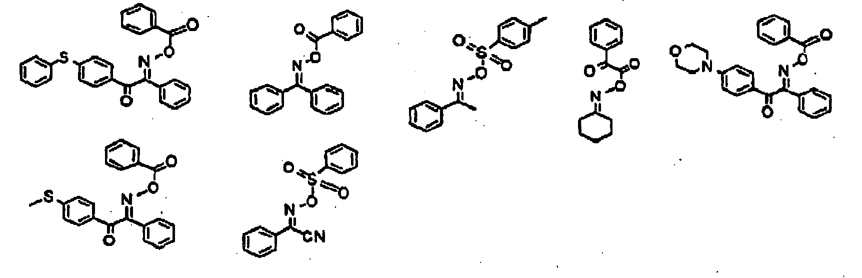

Examples of the onium salt compound include onium salts such as diazonium salts described in S.I. Schlesinger, Photogr. Sci. Eng., 18, 387 (1974) and T.S. Bal et al., Polymer, 21, 423 (1980), ammonium salts described in U.S. Patent 4,069,055 and JP-A-4-365049, phosphonium salts described in U.S. Patents 4,069,055 and 4,069,056, iodonium salts described in European Patent 104,143, U.S. Patents 339,049 and 410,201, JP-A-2-150848, and JP-A-2-296514, sulfonium salts described in European Patents 370,693, 390,214, 233,567, 297,443 and 297,442, U.S. Patents 4,933,377, 161,811, 410,201, 339,049, 4,760,013, 4,734,444 and 2,833,827, and German Patents 2,904,626, 3,604,580 and 3,604,581, selenonium salts described in J.V. Crivello et al., Macromolecules, 10 (6), 1307 (1977) and J.V. Crivello et al., J. Polymer Sci., Polymer Chem. Ed., 17, 1047 (1979), and arsonium salts described in C.S. Wen et al., Teh. Proc. Conf. Rad. Curing ASIA, p. 478, Tokyo, Oct. (1988).

In view of reactivity and stability, the above-described oxime ester compounds, diazonium salts, iodonium salts and sulfonium salt are preferred. In the present invention, such an onium salt functions not as an acid generator but as an ionic radical polymerization initiator.

The onium salt suitably used in the present invention is an onium salt represented by any one of the following formulae (RI-I) to (RI-III):

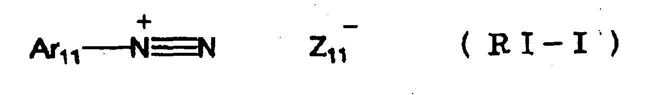

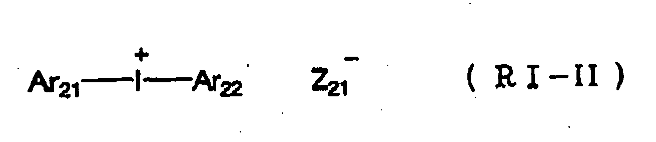

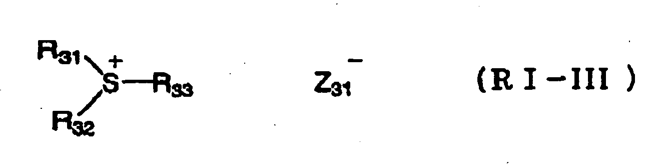

In formula (RI-I), Ar₁₁ represents an aryl group having a carbon number of 20 or less, which may have from 1 to 6 substituent(s), and preferred examples of the substituent include an alkyl group having a carbon number of 1 to 12, an alkenyl group having a carbon number of 1 to 12, an alkynyl group having a carbon number of 1 to 12, an aryl group having a carbon number of 1 to 12, an alkoxy group having a carbon number of 1 to 12, an aryloxy group having a carbon number of 1 to 12, a halogen atom, an alkylamino group having a carbon number of 1 to 12, a dialkylamino group having a carbon number of 1 to 12, an alkylamido or arylamido group having a carbon number of 1 to 12, a carbonyl group, a carboxyl group, a cyano group, a sulfonyl group, a thioalkyl group having a carbon number of 1 to 12, and a thioaryl group having a carbon number of 1 to 12. Z₁₁⁻ represents a monovalent anion and specific examples thereof include halogen ion, perchlorate ion, hexafluorophosphate ion, tetrafluoroborate ion, sulfonate ion, sulfinate ion, thiosulfonate ion and sulfate ion. Among these, preferred in view of stability are perchlorate ion, hexafluorophosphate ion, tetrafluoroborate ion, sulfonate ion and sulfinate ion.

In formula (RI-II), Ar₂₁ and Ar₂₂ each independently represents an aryl group having a carbon number of 20 or less, which may have from 1 to 6 substituent(s), and preferred examples of the substituent include an alkyl group having a carbon number of 1 to 12, an alkenyl group having a carbon number of 1 to 12, an alkynyl group having a carbon number of 1 to 12, an aryl group having a carbon number of 1 to 12, an alkoxy group having a carbon number of 1 to 12, an aryloxy group having a carbon number of 1 to 12, a halogen atom, an alkylamino group having a carbon number of 1 to 12, a dialkylamino group having a carbon number of 1 to 12, an alkylamido or arylamido group having a carbon number of 1 to 12, a carbonyl group, a carboxyl group, a cyano group, a sulfonyl group, a thioalkyl group having a carbon number of 1 to 12, and a thioaryl group having a carbon number of 1 to 12. Z₂₁⁻ represents a monovalent anion and specific examples thereof include halogen ion, perchlorate ion, hexafluorophosphate ion, tetrafluoroborate ion, sulfonate ion, sulfinate ion, thiosulfonate ion and sulfate ion. Among these, preferred in view of stability and reactivity are perchlorate ion, hexafluorophosphate ion, tetrafluoroborate ion, sulfonate ion, sulfinate ion and carboxylate ion.

In formula (RI-III), R₃₁, R₃₂ and R₃₃ each independently represents an aryl, alkyl, alkenyl or alkynyl group having a carbon number of 20 or less, which may have from 1 to 6 substituent(s), and in view of reactivity and stability, preferably an aryl group. Examples of the substituent include an alkyl group having a carbon number of 1 to 12, an alkenyl group having a carbon number of 1 to 12, an alkynyl group having a carbon number of 1 to 12, an aryl group having a carbon number of 1 to 12, an alkoxy group having a carbon number of 1 to 12, an aryloxy group having a carbon number of 1 to 12, a halogen atom, an alkylamino group having a carbon number of 1 to 12, a dialkylamino group having a carbon number of 1 to 12, an alkylamido or arylamido group having a carbon number of 1 to 12, a carbonyl group, a carboxyl group, a cyano group, a sulfonyl group, a thioalkyl group having a carbon number of 1 to 12, and a thioaryl group having a carbon number of 1 to 12. Z₃₁⁻ represents a monovalent anion and specific examples thereof include halogen ion, perchlorate ion, hexafluorophosphate ion, tetrafluoroborate ion, sulfonate ion, sulfinate ion, thiosulfonate ion, sulfate ion and carboxylate ion. Among these, preferred in view of stability and reactivity are perchlorate ion, hexafluorophosphate ion, tetrafluoroborate ion, sulfonate ion, sulfinate ion and carboxylate ion. The monovalent anion is more preferably carboxylate ion described in JP-A-2001-343742, still more preferably carboxylate ion described in JP-A-2002-148790.

Specific examples of the onium salt compound which can be suitably used in the present invention are set forth below, but the present invention is not limited thereto.

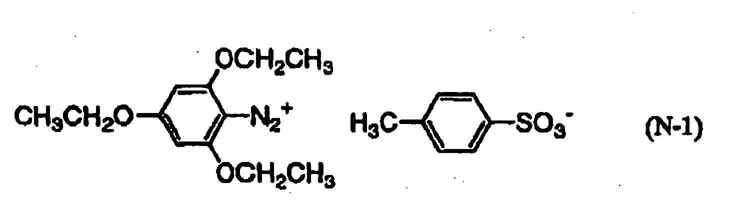

PF₆⁻ (N-2)

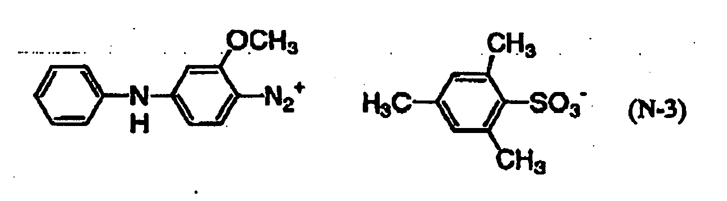

ClO₄⁻ (N-4)

PF₆⁻ (N-5)

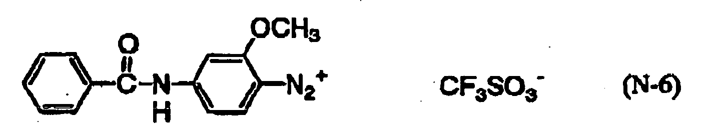

BF₄⁻ (N-7)

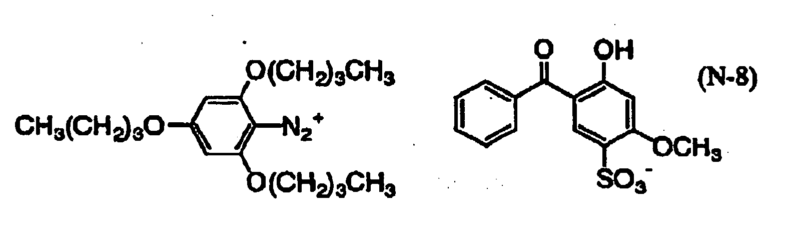

ClO₄⁻ (N-9)

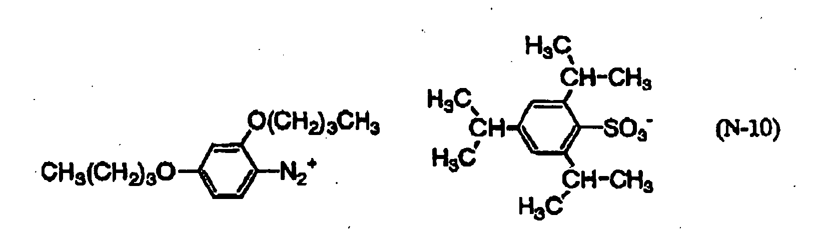

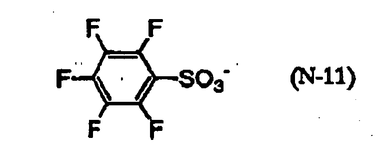

PF₆⁻ (N-12)

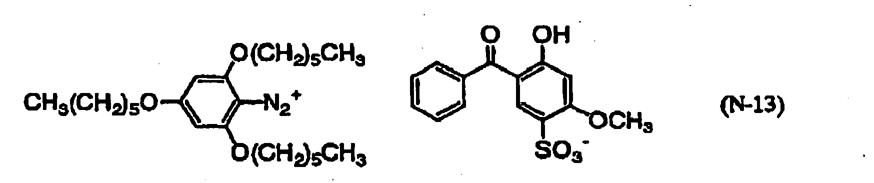

ClO₄⁻ (N-14)

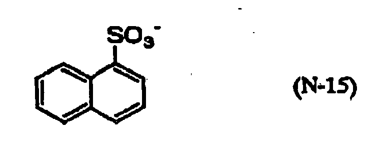

PF₆⁻ (N-16)

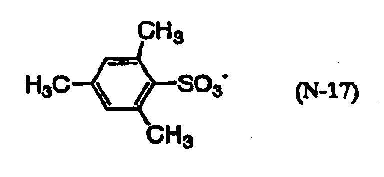

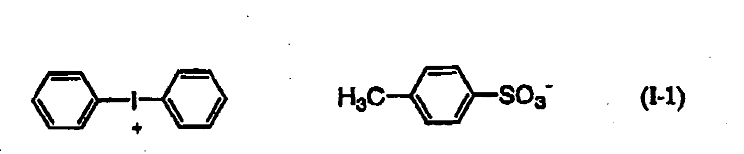

PF₆⁻ (I-2)

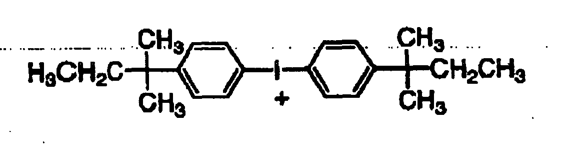

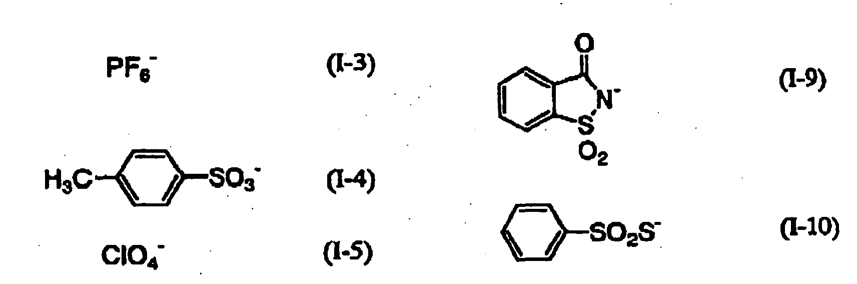

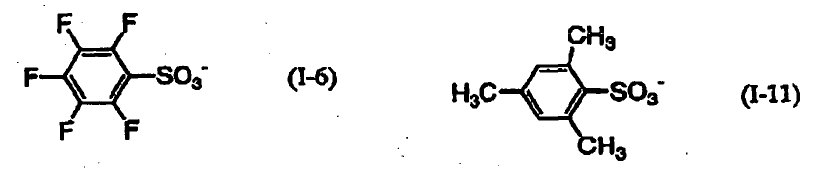

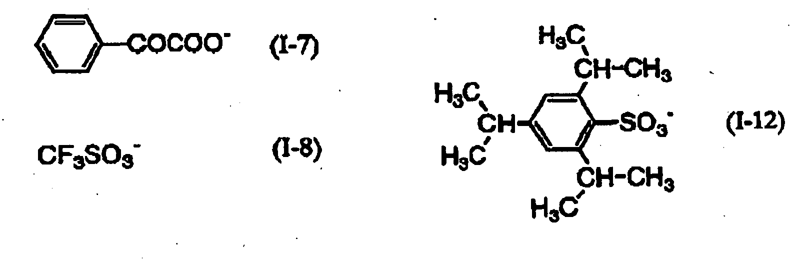

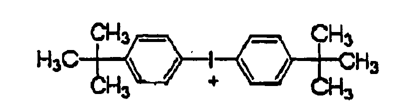

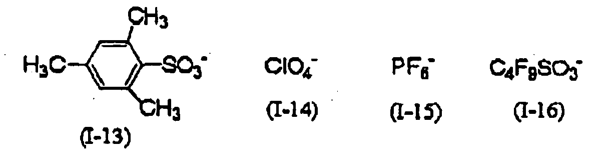

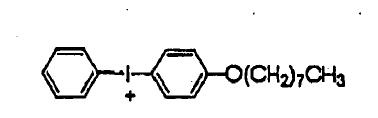

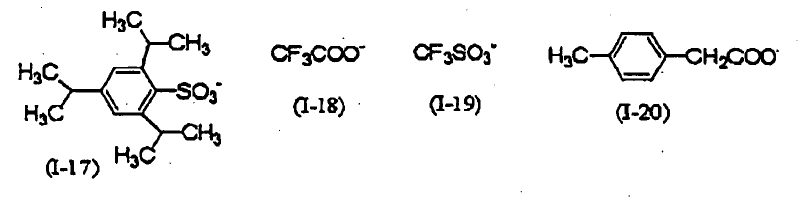

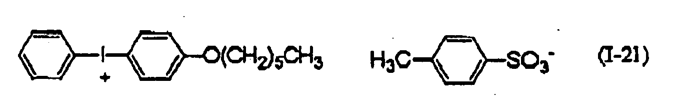

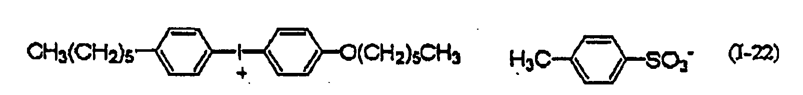

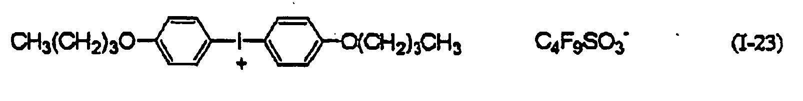

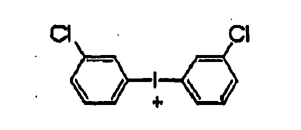

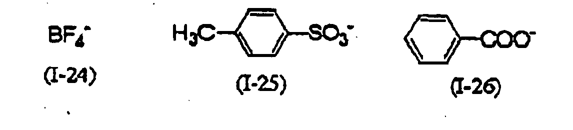

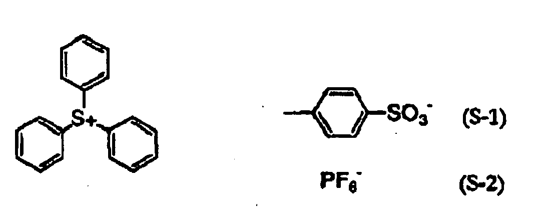

ClO₄⁻ (S-3)

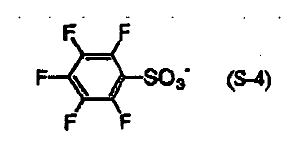

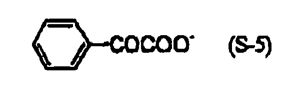

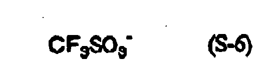

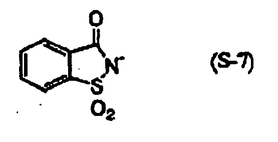

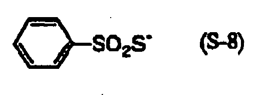

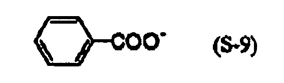

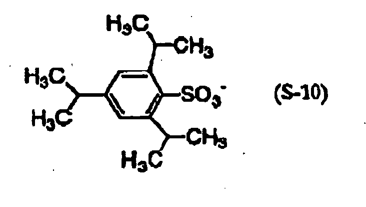

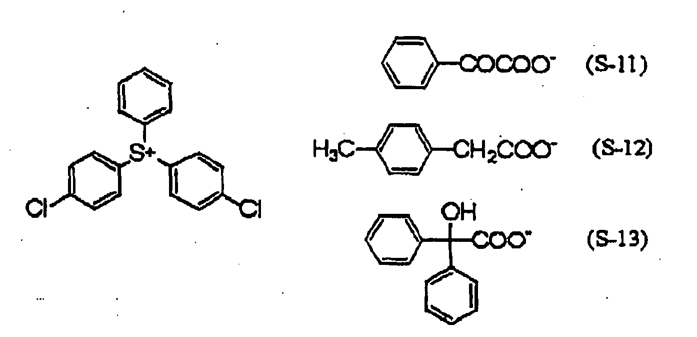

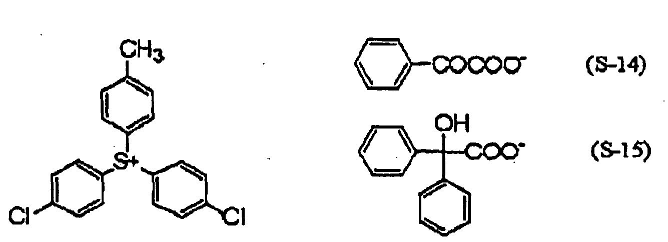

BF₄⁻ (S-16)

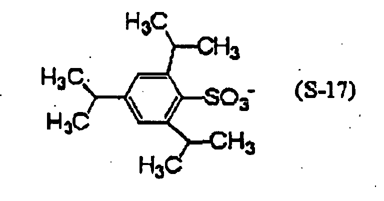

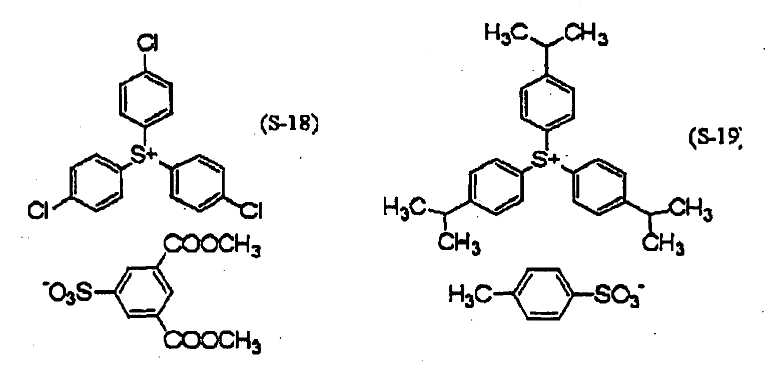

This polymerization initiator may be added at a ratio of preferably from 0.1 to 50 mass%, more preferably from 0.5 to 30 mass%, still more preferably from 1 to 20 mass%, based on all solid contents constituting the image forming layer. Within this range, good sensitivity and good contamination resistance of the non-image area at the printing can be obtained. Only one of these polymerization initiators may be used, or two or more species thereof may be used in combination. Also, the polymerization initiator may be added together with other components in the same layer or may be added to a layer provided separately.

### <(C) Radical Polymerizable Compound>

In the present invention, the polymerizable compound used in the image forming layer is an addition-polymerizable compound having at lease one ethylenically unsaturated double bond and is selected from compounds having at least one, preferably two or more, terminal ethylenically unsaturated bond(s). Such compounds are widely known in this industrial field and these known compounds can be used in the present invention without any particular limitation. These compounds have a chemical mode such as monomer, prepolymer (that is, dimer, trimer or oligomer) or a mixture or copolymer thereof. Examples of the monomer and its copolymer include an unsaturated carboxylic acid (e.g., acrylic acid, methacrylic acid, itaconic acid, crotonic acid, isocrotonic acid, maleic acid), and esters and amides thereof. Among these, preferred are esters of an unsaturated carboxylic acid with an aliphatic polyhydric alcohol compound, and amides of an unsaturated carboxylic acid with an aliphatic polyvalent amine compound. Also, for example, addition reaction products of an unsaturated carboxylic acid ester or amide having a nucleophilic substituent such as hydroxyl group, amino group or mercapto group with a monofunctional or polyfunctional isocyanate or epoxy, and dehydrating condensation reaction products with a monofunctional or polyfunctional carboxylic acid may be suitably used. Furthermore, addition reaction products of an unsaturated carboxylic acid ester or amide having an electrophilic substituent such as isocyanate group or epoxy group with a monofunctional or polyfunctional alcohol, amine or thiol, and displacement reaction products of an unsaturated carboxylic acid ester or amide having a disorptive substituent such as halogen group or tosyloxy group with a monofunctional or polyfunctional alcohol, amine or thiol may also be suitably used. In addition, compounds where the unsaturated carboxylic acid of the above-described compounds is replaced by an unsaturated phosphonic acid, styrene, vinyl ether or the like, may also be used.

Specific examples of the ester monomer of an aliphatic polyhydric alcohol compound and an unsaturated carboxylic acid include the followings. Examples of the acrylic acid ester include ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl)isocyanurate, isocyanuric acid ethylene oxide (EO)-modified triacrylate, polyester acrylate oligomer and isocyanuric acid EO-modified triacrylate.

Examples of the methacrylic acid ester include tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)-phenyl]dimethylmethane and bis[p-(methacryloxyethoxy)phenyl]dimethylmethane.

Examples of the itaconic acid ester include ethylene glycol diitaconate, propylene glycol diitaconate, 1,3-butanediol diitaconate, 1,4-butanediol diitaconate, tetramethylene glycol diitaconate, pentaerythritol diitaconate and sorbitol tetraitaconate. Examples of the crotonic acid ester include ethylene glycol dicrotonate, tetramethylene glycol dicrotonate, pentaerythritol dicrotonate and sorbitol tetradicrotonate. Examples of the isocrotonic acid ester include ethylene glycol diisocrotonate, pentaerythritol diisocrotonate and sorbitol tetraisocrotonate. Examples of the maleic acid ester include ethylene glycol dimaleate, triethylene glycol dimaleate, pentaerythritol dimaleate and sorbitol tetramaleate.

Other examples of the ester include aliphatic alcohol-based esters described in JP-B-51-47334 and JP-A-57-196231, those having an aromatic skeleton described in JP-A-59-5240, JP-A-59-5241 and JP-A-2-226149, and those containing an amino group described in JP-A-1-165613. These ester monomers may also be used as a mixture.

Specific examples of the amide monomer of an aliphatic polyvalent amine compound and an unsaturated carboxylic acid include methylenebisacrylamide, methylenebismethacrylamide, 1,6-hexamethylenebisacrylamide, 1,6-hexamethylenebismethacrylamide, diethylenetriaminetrisacrylamide, xylylenebisacrylamide and xylylenebismethacrylamide. Other preferred examples of the amide-type monomer include those having a cyclohexylene structure described in JP-B-54-21726.

A urethane-based addition-polymerizable compound produced using an addition reaction of isocyanate and a hydroxyl group is also preferred and specific examples thereof include vinyl urethane compounds having two or more polymerizable vinyl groups within one molecule described in JP-B-48-41708, which are obtained by adding a vinyl monomer having a hydroxyl group represented by the following formula (II) to a polyisocyanate compound having two or more isocyanate groups within one molecule:

CH₂=C(R₄)COOCH₂CH(R₅)OH (II)

(wherein R₄ and R₅ each represents H or CH₃).

Other than these, urethane acrylates described in JP-A-51-37193, JP-B-2-32293 and JP-B-2-16765, and urethane compounds having an ethylene oxide-type skeleton described in JP-B-58-49860, JP-B-56-17654, JP-B-62-39417 and JP-B-62-39418 may also be suitably used. Furthermore, when addition-polymerizable compounds having an amino or sulfide structure within the molecule described in JP-A-63-277653, JP-A-63-260909 and JP-A-1-105238 are used, a photopolymerizable composition having very excellent photosensitization speed can be obtained.

Other examples include polyfunctional acrylates and methacrylates such as polyester acrylates described in JP-A-48-64183, JP-B-49-43191 and JP-B-52-30490 and epoxy acrylates obtained by reacting an epoxy resin with a (meth)acrylic acid. In addition, specific unsaturated compounds described in JP-B-46-43946, JP-B-1-40337 and JP-B-1-40336, and vinyl phosphonic acid-based compounds described in JP-A-2-25493 may be used. In some cases, a perfluoroalkyl group-containing structure described in JP-A-61-22048 is suitably used. Furthermore, those described as a photocurable monomer or oligomer in Adhesion, Vol. 20, No. 7, pp. 300-308 (1984) may also be used.

Details of the use method of these polymerizable compounds, such as structure, sole or combination use and amount added, can be freely selected in accordance with the designed performance of the final lithographic printing plate precursor. For example, these are selected from the following standpoints.

In view of sensitivity, a structure having a large unsaturated group content per one molecule is preferred and in most cases, a bifunctional or greater functional compound is preferred. For increasing the strength of the image area, namely, the cured layer, a trifunctional or greater functional compound is preferred. Also, a method of controlling both the sensitivity and the strength by using a combination of compounds differing in the functional number or differing in the polymerizable group (for example, an acrylic acid ester, a methacrylic acid ester, a styrene-based compound or a vinyl ether-based compound) is effective.

The selection and use method of the polymerizable compound are important factors also for the compatibility and dispersibility with other components (e.g., binder polymer, initiator, colorant) in the image forming layer. For example, the compatibility may be improved in some cases by using a low purity compound or using two or more species in combination. Also, a specific structure may be selected for the purpose of improving the adhesion to the support.

In the image forming layer, the polymerizable compound is preferably used in an amount of 5 to 80 mass%, more preferably from 25 to 75 mass. Also, one of these polymerizable compounds may be used alone, or two or more species thereof may be used in combination. In addition, as for the use method of the polymerizable compound, an appropriate structure, formulation or amount added can be freely selected by taking into account the degree of polymerization inhibition due to oxygen, the resolution, the fogging, the change of refractive index, the surface tackiness and the like. Depending on the case, the layer construction-coating method of undercoat and overcoat can also be employed.

### <(D) Binder Polymer>

In the present invention, a binder polymer may be used for enhancing the film property or on-press developability of the image forming layer. As for the binder polymer, conventionally known binder polymers can be used without limitation, and a polymer having film property is preferred. Examples of such a binder polymer include acrylic resin, polyvinyl acetal resin, polyurethane resin, polyurea resin, polyimide resin, polyamide resin, epoxy resin, methacrylic resin, polystyrene-based resin, novolak-type phenol-based resin, polyester resin, synthetic rubber and natural rubber.

The binder polymer may have crosslinking property so as to enhance the film strength of the image area. The crosslinking property may be imparted to the binder polymer by introducing a crosslinking functional group such as ethylenically unsaturated bond into the main or side chain of the polymer. The crosslinking functional group may be introduced by copolymerization.

Examples of the polymer having an ethylenically unsaturated bond in the main chain of the molecule include poly-1,4-butadiene and poly-1,4-isoprene.

Examples of the polymer having an ethylenically unsaturated bond in the side chain of the molecule include a polymer which is a polymer of acrylic or methacrylic acid ester or amide and in which the ester or amide residue (R in -COOR or -CONHR) has an ethylenically unsaturated bond.

Examples of the residue (R above) having an ethylenically unsaturated bond include -(CH₂)ₙCR¹=CR²R³, -(CH₂O)ₙCH₂CR¹=CR²R³, -(CH₂CH₂O)ₙCH₂CR¹=CR²R³, -(CH₂)ₙNH-CO-O-CH₂CR¹=CR²R³, -(CH₂)ₙ-O-CO-CR¹=CR²R³ and -(CH₂CH₂O)₂-X (wherein R¹ to R³ each represents a hydrogen atom, a halogen atom or an alkyl, aryl, alkoxy or aryloxy group having a carbon number of 1 to 20, R¹ and R² or R³ may combine with each other to form a ring, n represents an integer of 1 to 10, and X represents a dicyclopentadienyl residue).

Specific examples of the ester residue include -CH₂CH=CH₂ (described in JP-B-7-21633), -CH₂CH₂O-CH₂CH=CH₂, -CH₂C(CH₃)=CH₂, -CH₂CH=CH-C₆H₅, -CH₂CH₂OCOCH=CH-C₆H₅, -CH₂CH₂-NHCOO-CH₂CH=CH₂ and -CH₂CH₂O-X (wherein X represents a dicyclopentadienyl residue).

Specific examples of the amide residue include -CH₂CH=CH₂, -CH₂CH₂-Y (wherein Y represents a cyclohexene residue) and -CH₂CH₂-OCO-CH=CH₂.

In the binder polymer having crosslinking property, for example, a free radical (a polymerization initiating radical or a radical grown in the polymerization process of a polymerizable compound) is added to the crosslinking functional group to cause addition-polymerization between polymers directly or through a polymerization chain of the polymerizable compound, as a result, crosslinking is formed between polymer molecules and thereby curing is effected. Alternatively, an atom (for example, a hydrogen atom on the carbon atom adjacent to the functional crosslinking group) in the polymer is withdrawn by a free radical to produce a polymer radical and the polymer radicals combine with each other to form crosslinking between polymer molecules, thereby effecting curing.

The content of the crosslinking group (the radical-polymerizable unsaturated double bond content determined by iodine titration) in the binder polymer is preferably from 0.1 to 10.0 mmol, more preferably from 1.0 to 7.0 mmol, and most preferably from 2.0 to 5.5 mmol, per g of the binder polymer. Within this range, good sensitivity and good storage stability can be obtained.

In view of the on-press developability of the image forming layer in the unexposed area, the binder polymer preferably has high solubility or dispersibility in the ink and/or fountain solution.

For enhancing the solubility or dispersibility in the ink, the binder polymer is preferably lipophilic and for enhancing the solubility or dispersibility in the fountain solution, the binder polymer is preferably hydrophilic. Therefore, it is also effective in the present invention to use a lipophilic binder polymer and a hydrophilic binder polymer in combination.

Examples of the hydrophilic binder polymer which can be suitably used include those having a hydrophilic group such as hydroxy group, carboxyl group, carboxylate group, hydroxyethyl group, polyoxyethyl group, hydroxypropyl group, polyoxypropyl group, amino group, aminoethyl group, aminopropyl group, ammonium group, amide group, carboxymethyl group, sulfonic acid group and phosphoric acid group.

Specific examples thereof include gum arabic, casein, gelatin, a starch derivative, carboxymethyl cellulose and a sodium salt thereof, cellulose acetate, sodium alginate, vinyl acetate-maleic acid copolymers, styrene-maleic acid copolymers, polyacrylic acids and salts thereof, polymethacrylic acids and salts thereof, a homopolymer and a copolymer of hydroxyethyl methacrylate, a homopolymer and a copolymer of hydroxyethyl acrylate, a homopolymer and a copolymer of hydroxypropyl methacrylate, a homopolymer and a copolymer of hydroxypropyl acrylate, a homopolymer and a copolymer of hydroxybutyl methacrylate, a homopolymer and a copolymer of hydroxybutyl acrylate, polyethylene glycols, hydroxypropylene polymers, polyvinyl alcohols, a hydrolyzed polyvinyl acetate having a hydrolysis degree of 60 mol% or more, preferably 80 mol% or more, polyvinyl formal, polyvinyl butyral, polyvinylpyrrolidone, a homopolymer and a copolymer of acrylamide, a homopolymer and a copolymer of methacrylamide, a homopolymer and a copolymer of N-methylolacrylamide, polyvinylpyrrolidone, an alcohol-soluble nylon, and a polyether of 2,2-bis-(4-hydroxyphenyl)propane with epichlorohydrin.

The mass average molecular weight of the binder polymer is preferably 5,000 or more, more preferably from 10,000 to 300,000. The number average molecular weight is preferably 1,000 or more, more preferably from 2,000 to 250,000. The polydispersity (mass average molecular weight/number average molecular weight) is preferably from 1.1 to 10.

The binder polymer content is preferably from 5 to 90 mass%, more preferably from 5 to 80 mass%, still more preferably from 10 to 70 mass%, based on the entire solid content of the image forming layer. Within this range, good strength of image area and good image-forming property can be obtained.

The polymerizable compound and the binder polymer are preferably used in amounts of giving a mass ratio of 0.5/1 to 4/1.

### <Microcapsule and Microgel>

In the present invention, as the method for incorporating those image recording layer-constituting components (A) to (D) and other constituent components described later into the image recording layer, several embodiments may be used. One embodiment is a molecular dispersion-type image recording layer described, for example, in JP-A-2002-287334, which is formed by dissolving the constituent components in an appropriate solvent and coating the resulting solution. Another embodiment is a microcapsule-type image recording layer described, for example, in JP-A-2001-277740 and JP-A-2001-277742, where all or a part of the constituent components are enclosed in a microcapsule and incorporated into the image recording layer. In the microcapsule-type image recording layer, the constituent components may be incorporated also outside the microcapsule. Here, it is a preferred embodiment of the microcapsule-type image recording layer that hydrophobic constituent components are enclosed in a microcapsule and hydrophilic components are incorporated outside the microcapsule. Still another embodiment is an image recording layer containing a crosslinked resin particle, namely, a microgel. The microgel may contain a part of the constituent components (A) to (D) in the inside and/or on the surface of the microgel. Particularly, an embodiment where the microgel is made to be a reactive microgel by virtue of having (C) the polymerizable compound on the surface thereof is preferred in view of image-forming sensitivity and press life.

In order to obtain higher on-press developability, the image recording layer is preferably a microcapsule-type or microgel-type image recording layer.

As for the method of microencapsulating or microgelling the image recording layer-constituting components, known methods can be applied.

Examples of the method for producing a microcapsule include, but are not limited to, a method utilizing coacervation described in U.S. Patents 2,800,457 and 2,800,458, a method utilizing interfacial polymerization described in U.S. Patent 3,287,154, JP-B-38-19574 and JP-B-42-446, a method utilizing precipitation of a polymer described in U.S. Patents 3,418,250 and 3,660,304, a method using an isocyanate polyol wall material described in U.S. Patent 3,796,669, a method using an isocyanate wall material described in U.S. Patent 3,914,511, a method using a urea-formaldehyde or urea-formaldehyde-resorcinol wall-forming material described in U.S. Patents 4,001,140, 4,087,376 and 4,089,802, a method using a wall material such as melamine-formaldehyde resin or hydroxy cellulose described in U.S. Patent 4,025,445, an *in situ* method by monomer polymerization described in JP-B-36-9163 and JP-B-51-9079, a spray drying method described in British Patent 930,422 and U.S. Patent 3,111,407, and an electrolytic dispersion cooling method described in British Patents 952,807 and 967,074.

The microcapsule wall for use in the present invention preferably has three-dimensional crosslinking and has a property of swelling with a solvent. In this viewpoint, the wall material of the microcapsule is preferably polyurea, polyurethane, polyester, polycarbonate, polyamide or a mixture thereof, more preferably polyurea or polyurethane. Also, a compound having a crosslinking functional group such as ethylenically unsaturated bond introducible into a binder polymer which is described later may be introduced into the microcapsule wall.

On the other hand, the microgel may be prepared by a granulation method utilizing interfacial polymerization described in JP-B-38-19574 and JP-B-42-446, or a granulation method utilizing non-aqueous dispersion polymerization described in JP-A-5-61214, but the present invention is not limited to these methods.

As for the method utilizing interfacial polymerization, the above-described known methods for producing a microcapsule may be applied.

The microgel for use in the present invention is preferably a microgel having three-dimensional crosslinking and being granulated by interfacial polymerization. From this standpoint, the material used therefor is preferably polyurea, polyurethane, polyester, polycarbonate, polyamide or a mixture thereof, more preferably polyurea or polyurethane.

The average particle diameter of the microcapsule or microgel is preferably from 0.01 to 3.0 µm, more preferably from 0.05 to 2.0 µm, still more preferably from 0.10 to 1.0 µm. Within this range, high resolution and good aging stability can be obtained.

### <Surfactant>

In the present invention, a surfactant is preferably used in the image forming layer so as to accelerate the on-press development at the initiation of printing and enhance the coated surface state. The surfactant includes a nonionic surfactant, an anionic surfactant, a cationic surfactant, an amphoteric surfactant, a fluorine-containing surfactant and the like. One surfactant may be used alone, or two or more species may be used in combination.

The nonionic surfactant for use in the present invention is not particularly limited and a conventionally known nonionic surfactant can be used. Examples thereof include polyoxyethylene alkyl ethers, polyoxyethylene alkylphenyl ethers, polyoxyethylene polystyrylphenyl ethers, polyoxyethylene polyoxypropylene alkyl ethers, glycerin fatty acid partial esters, sorbitan fatty acid partial esters, pentaerythritol fatty acid partial esters, propylene glycol monofatty acid esters, sucrose fatty acid partial esters, polyoxyethylene sorbitan fatty acid partial esters, polyoxyethylene sorbitol fatty acid partial esters, polyethylene glycol fatty acid esters, polyglycerin fatty acid partial esters, polyoxyethylenated castor oils, polyoxyethylene glycerin fatty acid partial esters, fatty acid diethanolamides, N,N-bis-2-hydroxyalkylamines, polyoxyethylene alkylamine, triethanolamine fatty acid ester, trialkylamine oxide, polyethylene glycol, and a copolymer of polyethylene glycol and polypropylene glycol.

The anionic surfactant for use in the present invention is not particularly limited and a conventionally known anionic surfactant can be used. Examples thereof include fatty acid salts, abietates, hydroxyalkanesulfonates, alkanesulfonates, dialkylsulfosuccinic ester salts, linear alkylbenzenesulfonates, branched alkylbenzenesulfonates, alkylnaphthalenesulfonates, alkylphenoxypolyoxyethylenepropylsulfonates, polyoxyethylenealkylsulfophenyl ether salts, N-methyl-N-oleyltaurine sodium salt, N-alkylsulfosuccinic acid monoamide disodium salt, petroleum sulfonates, sulfated beef tallow oil, sulfuric ester salts of fatty acid alkyl ester, alkylsulfuric ester salts, polyoxyethylene alkyl ether sulfuric ester salts, fatty acid monoglyceride sulfuric ester salts, polyoxyethylene alkylphenyl ether sulfuric ester salts, polyoxyethylene styrylphenyl ether sulfuric ester salts, alkylphosphoric ester salts, polyoxyethylene alkyl ether phosphoric ester salts, polyoxyethylene alkylphenyl ether phosphoric ester salts, partially saponified styrene/maleic anhydride copolymers, partially saponified olefin/maleic anhydride copolymers, and naphthalenesulfonate formalin condensates.

The cationic surfactant for use in the present invention is not particularly limited and a conventionally known cationic surfactant can be used. Examples thereof include alkylamine salts, quaternary ammonium salts, polyoxyethylenealkylamine salts and polyethylene polyamine derivatives.

The amphoteric surfactant for use in the present invention is not particularly limited and a conventionally known amphoteric surfactant can be used. Examples thereof include carboxybetaines, aminocarboxylic acids, sulfobetaines, aminosulfuric esters and imidazolines.

The term "polyoxyethylene" in the above-described surfactants can be instead read as "polyoxyalkylene" such as polyoxymethylene, polyoxypropylene or polyoxybutylene, and these surfactants can also be used in the present invention.

The surfactant is more preferably a fluorine-containing surfactant containing a perfluoroalkyl group within the molecule. This fluorine-containing surfactant includes an anionic type such as perfluoroalkylcarboxylate, perfluoroalkylsulfonate and perfluoroalkylphosphoric ester; an amphoteric type such as perfluoroalkylbetaine; a cationic type such as perfluoroalkyltrimethylammonium salt; and a nonionic type such as perfluoroalkylamine oxide, perfluoroalkyl ethylene oxide adduct, oligomer containing a perfluoroalkyl group and a hydrophilic group, oligomer containing a perfluoroalkyl group and a lipophilic group, oligomer containing a perfluoroalkyl group, a hydrophilic group and a lipophilic group, and urethane containing a perfluoroalkyl group and a lipophilic group. In addition, fluorine-containing surfactants described in JP-A-62-170950, JP-A-62-226143 and JP-A-60-168144 may also be suitably used.

One surfactant may be used alone, or two or more species may be used in combination.

The surfactant content is preferably from 0.001 to 10 mass%, more preferably from 0.01 to 5 mass%, based on the entire solid content of the image forming layer.

### <Printing-Out Agent>

In the image forming layer used in the present invention, a compound capable of undergoing change in the color by the effect of an acid or a radical can be added so as to produce a print-out image. However, since the unexposed area is developed and removed on a printing press, in view of ink contamination, the compound before change in color preferably has substantially no absorption in the visible region. Examples of this compound include various coloring matters such as diphenylmethane type, triphenylmethane type, thiazine type, oxazine type, xanthene type, anthraquinone type, iminoquinone type, azo type and azomethine type.

Other suitable examples include a leuco dye known as a material for heat-sensitive or pressure-sensitive paper.

The dye capable of undergoing change in the color by the effect of an acid or a radical is added suitably to an extent of having substantially no absorption in the visible region as described above and specifically, the absorbance at the maximum absorption is preferably 0.1 or less.

### <Polymerization Inhibitor>

In the image forming layer used in the present invention, a small amount of a thermopolymerization inhibitor is preferably added so as to prevent unnecessary thermopolymerization of (C) the radical polymerizable compound during the production or storage of the image forming layer.

Suitable examples of the thermopolymerization inhibitor include hydroquinone, p-methoxyphenol, di-tert-butyl-p-cresol, pyrogallol, tert-butyl catechol, benzoquinone, 4,4'-thiobis(3-methyl-6-tert-butylphenol), 2,2'-methylenebis(4-methyl-6-tertbutylphenol) and N-nitroso-N-phenylhydroxylamine aluminum salt.

The amount of the thermopolymerization inhibitor added is preferably from about 0.01 to about 5 mass% based on the entire solid content of the image forming layer.

### <Higher Fatty Acid Derivative, etc.>

In the image forming layer used in the present invention, a higher fatty acid derivative such as behenic acid or behenic acid amide may be added to localize on the surface of the image forming layer during drying after coating so as to prevent polymerization inhibition by oxygen. The amount of the higher fatty acid derivative added is preferably from about 0.1 to about 10 mass% based on the entire solid content of the image recording layer.

### <Plasticizer>

The image forming layer used in the present invention may contain a plasticizer for enhancing the on-press developability.

Suitable examples of the plasticizer include phthalic acid esters such as dimethyl phthalate, diethyl phthalate, dibutyl phthalate, diisobutyl phthalate, diocyl phthalate, octyl capryl phthalate, dicyclohexyl phthalate, ditridecyl phthalate, butyl benzyl phthalate, diisodecyl phthalate and diallyl phthalate; glycol esters such as dimethyl glycol phthalate, ethyl phthalylethyl glycolate, methyl phthalylethyl glycolate, butyl phthalylbutyl glycolate and triethylene glycol dicaprylic acid ester; phosphoric acid esters such as tricresyl phosphate and triphenyl phosphate; aliphatic dibasic acid esters such as diisobutyl adipate, dioctyl adipate, dimethyl sebacate, dibutyl sebacate, dioctyl azelate and dibutyl maleate; polyglycidyl methacrylate, triethyl citrate, glycerin triacetyl ester and butyl laurate.

The plasticizer content is preferably about 30 mass% or less based on the entire solid content of the image forming layer.

### <Low-Molecular Hydrophilic Compound>

The image forming layer used in the present invention may contain a hydrophilic low-molecular compound so as to enhance the on-press developability. Examples of the hydrophilic low-molecular compound include, as the water-soluble organic compound, glycols and ether or ester derivatives thereof, such as ethylene glycol, diethylene glycol, triethylene glycol, propylene glycol, dipropylene glycol and tripropylene glycol; polyhydroxys such as glycerin and pentaerythritol; organic amines and salts thereof, such as triethanolamine, diethanolamine and monoethanolamine; organic sulfonic acids and salts thereof, such as toluenesulfonic acid and benzenesulfonic acid; organic phosphonic acids and salts thereof, such as phenylphosphonic acid; and organic carboxylic acids and salts thereof, such as tartaric acid, oxalic acid, citric acid, malic acid, lactic acid, gluconic acid and amino acids.

### <Formation of Image Forming Layer>

The image forming layer used in the present invention is formed by dispersing or dissolving the above-described necessary components in a solvent to prepare a coating solution and coating the obtained coating solution. Examples of the solvent used here include, but are not limited to, ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethylsulfoxide, sulfolane, γ-butyl lactone, toluene and water. These solvents are used individually or in combination. The solid content concentration of the coating solution is preferably from 1 to 50 mass%.

The image forming layer used in the present invention may also be formed by dispersing or dissolving the same or different components described above in the same or different solvents to prepare a plurality of coating solutions and repeating the coating and drying multiple times.

The coated amount (solid content) of the image forming layer obtained on the support after coating and drying varies depending on the use but, in general, is preferably from 0.3 to 3.0 g/m². Within this range, good sensitivity and good film properties of the image forming layer can be obtained.

For the coating, various methods may be used and examples thereof include bar coater coating, rotary coating, spray coating, curtain coating, dip coating, air knife coating, blade coating and roll coating.

### (Protective Layer)

In the lithographic printing plate precursor used in the present invention, if desired, a protective layer (overcoat layer) may be provided on the image forming layer, for example, for imparting oxygen blocking property, preventing generation of scratches or the like on the image forming layer, or preventing ablation at the exposure with a high-intensity laser.

The exposure of the lithographic printing plate is usually performed in air and the image forming reaction occurring in the image forming layer upon exposure may be inhibited by a low-molecular compound present in the air, such as oxygen and basic substance. The protective layer prevents this low molecular compound such as oxygen and basic substance from mixing into the image forming layer and thereby prevents the inhibition of the image-forming reaction in air. Accordingly, the property required of the protective layer is low permeability to a low molecular compound such as oxygen. Furthermore, the protective layer is a layer which is assured of good transparency to light used for exposure and excellent adhesion to the image forming layer and which can be easily removed during on-press development after exposure. The protective layer having such properties is described, for example, in U.S. patent 3,458,311 and JP-A-55-49729.

As for the material used for the protective layer, either a water-soluble polymer or a water-insoluble polymer may be appropriately selected and used. Specific examples thereof include a water-soluble polymer such as polyvinyl alcohol, modified polyvinyl alcohol, polyvinylpyrrolidone, polyvinylimidazole, polyacrylic acid, polyacrylamide, partially saponified polyvinyl acetate, ethylene-vinyl alcohol copolymer, water-soluble cellulose derivative, gelatin, starch derivative and gum arabic; and a water-insoluble polymer such as polyvinylidene chloride, poly(meth)acrylonitrile, polysulfone, polyvinyl chloride, polyethylene, polycarbonate, polystyrene, polyamide and cellophane. Two or more species of these polymers may be used in combination, if desired.

Among these materials, a relatively useful material is a water-soluble polymer compound with excellent crystallinity. Specific suitable examples thereof include polyvinyl alcohol, polyvinylpyrrolidone, polyvinylimidazole, a water-soluble acrylic resin such as polyacrylic acid, gelatin and gum arabic. In particular, polyvinyl alcohol, polyvinylpyrrolidone and polyvinylimidazole are preferred, because these can be coated using water as the solvent and can be easily removed with a fountain solution at the printing. Out of these, polyvinyl alcohol (PVA) gives most preferred results in view of fundamental properties such as oxygen blocking property and development removability.

The polyvinyl alcohol which can be used for the protective layer may be partially substituted by an ester, an ether or an acetal as long as it contains a substantial amount of an unsubstituted vinyl alcohol unit having necessary water solubility. Similarly, the polyvinyl alcohol may contain other copolymerization components. Examples of the polyvinyl alcohol which can be preferably used include polyvinyl alcohols having various polymerization degrees and randomly having various hydrophilic modified moieties such as an anion-modified moiety modified with anion (e.g., carboxyl group, sulfo group), a cation-modified moiety modified with cation (e.g., amino group, ammonium group), a silanol-modified moiety and a thiol-modified moiety; and polyvinyl alcohols having various polymerization degrees and having at the polymer chain terminal various modified moieties such as the above-described anion-modified moiety and cation-modified moiety, a silanol-modified moiety, a thiol-modified moiety, an alkoxyl-modified moiety, a sulfide-modified moiety, an ester-modified moiety modified with an ester of vinyl alcohol with various organic acids, an ester-modified moiety modified with an ester of the above-described anion-modified moiety with alcohols, and an epoxy-modified moiety.

Examples of such a modified polyvinyl alcohol include compounds hydrolyzed at 71 to 100 mol% and having a polymerization degree of 300 to 2,400. Specific examples of the polyvinyl alcohol include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8, all produced by Kuraray Co., Ltd. Also, specific examples of the modified polyvinyl alcohol include KL-318, KL-118, KM-618, KM-118 and SK-5102, which are a polyvinyl alcohol having an anion-modified moiety; C-318, C-118 and C-318, which are a polyvinyl alcohol having a cation-modified moiety; M-205 and M-115, which are a polyvinyl alcohol having a terminal thiol-modified moiety; MP-103, MP-203, MP-102 and MP-202, which are a polyvinyl alcohol having a terminal sulfide-modified moiety; HL-12E and HL-1203, which are a polyvinyl alcohol having at the terminal an ester-modified moiety modified by an ester with a higher fatty acid; and R-1130, R-2105 and R-2130, which are a polyvinyl alcohol having a reactive silane-modified moiety.

The protective layer also preferably contains a layered compound described above. The content of the inorganic layered compound in the protective layer is preferably from 5/1 to 1/100 in terms of the mass ratio to the amount of the binder used in the protective layer. Even in the case of using a plurality of inorganic layered compound species in combination, the total amount of these inorganic layered compounds preferably satisfies the above-described mass ratio.

As for other compositions of the protective layer, glycerin, dipropylene glycol or the like may be added in an amount corresponding to several mass% based on the (co)polymer so as to impart flexibility. Also, an anionic surfactant such as sodium alkylsulfate and sodium alkylsulfonate; an amphoteric surfactant such as alkylaminocarboxylate and alkylaminodicarboxylate; or a nonionic surfactant such as polyoxyethylene alkylphenyl ether, may be added. Such a surfactant may be added in an amount of 0.1 to 100 mass% based on the (co)polymer.

In order to enhance the adhesion to the image area, for example, JP-A-49-70702 and Unexamined British Patent Publication No. 1,303,578 describe a technique of mixing from 20 to 60 mass% of an acrylic emulsion, a water-insoluble vinylpyrrolidone-vinyl acetate copolymer or the like in a hydrophilic polymer mainly comprising polyvinyl alcohol, and stacking the polymer on the image forming layer, thereby obtaining sufficiently high adhesive property. In the present invention, these known techniques all can be used.

In the coating solution for protective layer, known additives such as an anionic, nonionic, cationic or fluorine-containing surfactant for enhancing the coating property and a water-soluble plasticizer for improving the physical properties of the layer can be added. Examples of the water-soluble plasticizer include propionamide, cyclohexanediol, glycerin and sorbitol. Furthermore, a water-soluble (meth)acrylate-based polymer may also be added. In addition, known additives for enhancing the adhesion to the image forming layer or the aging stability of the coating solution may be added to the coating solution.

The thus-prepared coating solution for protective layer is coated on the image forming layer provided on the support, and dried to form a protective layer. The coating solvent may be appropriately selected in relationship with the binder, but in the case of using a water-soluble polymer, distilled water or purified water is preferred. The coating method of the protective layer is not particularly limited, and a known method such as methods described in U.S. Patent 3,458,311 and JP-B-55-49729 may be applied. More specifically, the protective layer may be coated, for example, by a blade coating method, an air knife coating method, a gravure coating method, a roll coating method, a spray coating method, a dip coating method or a bar coating method.

The amount of the protective layer coated is, in terms of the coated amount after drying, preferably from 0.01 to 10 g/m², more preferably from 0.02 to 3 g/m², and most preferably from 0.02 to 1 g/m².

### (Support)

The support for use in the lithographic printing plate precursor used in the present invention is not particularly limited and may be sufficient if it is a dimensionally stable plate-like material. Examples of the support include paper, paper laminated with plastic (e.g., polyethylene, polypropylene, polystyrene), metal plate (e.g., aluminum, zinc, copper), plastic film (e.g., cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, polyvinyl acetal), and paper or plastic film laminated or vapor-deposited with the above-described metal. Among these supports, polyester film and aluminum plate are preferred, and aluminum plate is more preferred because this is dimensionally stable and relatively inexpensive.

The aluminum plate is a pure aluminum plate, an alloy plate mainly comprising aluminum and containing trace heteroelements, or an aluminum or aluminum alloy thin film laminated with plastic. Examples of the heteroelement contained in the aluminum alloy include silicon, iron, manganese, copper, magnesium, chromium, zinc, bismuth, nickel and titanium. The heteroelement content in the alloy is preferably 10 mass% or less. In the present invention, a pure aluminum plate is preferred, but perfectly pure aluminum is difficult to produce in view of refining technique and therefore, an aluminum plate containing trace heteroelements may be used. The aluminum plate is not particularly limited in its composition, and a conventionally known and commonly employed material can be appropriately used.

The thickness of the support is preferably from 0.1 to 0.6 mm, more preferably from 0.15 to 0.4 mm, still more preferably from 0.2 to 0.3 mm.

In advance of using the aluminum plate, a surface treatment such as surface roughening and anodization is preferably applied thereto. By this surface treatment, it becomes easy to enhance hydrophilicity and ensure adhesion between the image forming layer and the support. Before surface-roughening, the aluminum plate is degreased for removing the rolling oil on the surface, if desired, by using a surfactant, an organic solvent, an alkaline aqueous solution or the like.

The surface-roughening treatment of the aluminum plate surface is performed by various methods and examples thereof include a mechanical surface-roughening treatment, an electrochemical surface-roughening treatment (surface-roughening treatment of electrochemically dissolving the surface) and a chemical surface-roughening treatment (surface-roughening treatment of chemically and selectively dissolving the surface).

The mechanical surface-roughening treatment may be performed using a known method such as ball polishing, brush polishing, blast polishing and buff polishing.

The electrochemical surface-roughening treatment is performed, for example, by a method of passing an AC or DC current in an electrolytic solution containing an acid such as hydrochloric acid or nitric acid. Also, a method using a mixed acid described in JP-A-54-63902 may be used.

The surface-roughened aluminum plate is, if desired, subjected to an alkali etching treatment using an aqueous solution of potassium hydroxide, sodium hydroxide or the like and after a neutralization treatment, further subjected to an anodization treatment, if desired, so as to enhance the abrasion resistance.

As for the electrolyte used in the anodization treatment of the aluminum plate, various electrolytes of forming a porous oxide film may be used. In general, a sulfuric acid, a hydrochloric acid, an oxalic acid, a chromic acid or a mixed acid thereof is used. The electrolyte concentration may be appropriately determined according to the kind of the electrolyte.

The anodization treatment conditions vary depending on the electrolyte used and cannot be indiscriminately specified but, in general, the conditions are preferably such that the electrolyte concentration is from 1 to 80 mass%, the liquid temperature is from 5 to 70°C, the current density is from 5 to 60 A/dm², the voltage is from 1 to 100 V, and the electrolysis time is from 10 seconds to 5 minutes. The amount of the anodic oxide film formed is preferably from 1,0 to 5.0 g/m², more preferably from 1.5 to 4.0 g/m². Within this range, good press life and good scratch resistance in the non-image area of the lithographic printing plate can be obtained.

As for the support used in the present invention, the substrate having thereon an anodic oxide film after the above-described surface treatment may be used as it is but in order to more improve adhesion to the upper layer, hydrophilicity, scumming resistance, heat insulation and the like, for example, a treatment for enlarging micropores of the anodic oxide film, a pore-sealing treatment and a surface-hydrophilizing treatment of dipping the substrate in an aqueous solution containing a hydrophilic compound, described in JP-A-2001-253181 and JP-A-2001-322365, may be appropriately selected and applied. Of course, the enlarging treatment and pore-sealing treatment are not limited to those described in these patent publications and any conventionally known method may be employed.

For example, the pore-sealing treatment may be performed, in addition to pore-sealing with steam, by using fluorozirconic acid alone, using sodium fluoride, or using steam having added thereto lithium chloride.

The pore-sealing treatment for use in the present invention is not particularly limited, and a conventionally known method may be used. In particular, a pore-sealing treatment with an aqueous solution containing an inorganic fluorine compound, a pore-sealing treatment with water vapor, and a pore-sealing treatment with hot water are preferred. These treatments are described below.

The inorganic fluorine compound used in the pore-sealing treatment with an aqueous solution containing an inorganic fluorine compound is preferably a metal fluoride.

Specific examples thereof include sodium fluoride, potassium fluoride, calcium fluoride, magnesium fluoride, sodium fluorozirconate, potassium fluorozirconate, sodium fluorotitanate, potassium fluorotitanate, ammonium fluorozirconate, ammonium fluorotitanate, potassium fluorotitanate, fluorozirconic acid, fluorotitanic acid, hexafluorosilicic acid, nickel fluoride, iron fluoride, fluorophosphoric acid and ammonium fluorophosphate. Among these, sodium fluorozirconate, sodium fluorotitanate, fluorozirconic acid and fluorotitanic acid are preferred.

The concentration of the inorganic fluorine compound in the aqueous solution is, from the standpoint of satisfactorily sealing the micropores of the anodic oxide film, preferably 0.01 mass% or more, more preferably 0.05 mass% or more, and in view of scumming resistance, preferably 1 mass% or less, more preferably 0.5 mass% or less.

The aqueous solution containing an inorganic fluorine compound preferably further contains a phosphate compound. When a phosphate compound is contained, the hydrophilicity on the anodic oxide film surface is elevated and in turn, the on-press developability and scumming resistance can be enhanced.

Suitable examples of the phosphate compound include a phosphate of metal such as alkali metal and alkaline earth metal.

Specific examples thereof include zinc phosphate, aluminum phosphate, ammonium phosphate, diammonium hydrogenphosphate, ammonium dihydrogenphosphate, monoammonium phosphate, monopotassium phosphate, monosodium phosphate, potassium dihydrogenphosphate, dipotassium hydrogenphosphate, calcium phosphate, sodium ammonium hydrogenphosphate, magnesium hydrogenphosphate, magnesium phosphate, ferrous phosphate, ferric phosphate, sodium dihydrogenphosphate, sodium phosphate, disodium hydrogenphosphate, lead phosphate, diammonium phosphate, calcium dihydrogenphosphate, lithium phosphate, phosphotungstic acid, ammonium phosphotungstate, sodium phosphotungstate, ammonium phosphomolybdate, sodium phosphomolybdate, sodium phosphite, sodium tripolyphosphate and sodium pyrophosphate. Among these, sodium dihydrogenphosphate, disodium hydrogenphosphate, potassium dihydrogenphosphate and dipotassium hydrogenphosphate are preferred.

The combination of the inorganic fluorine compound and the phosphate compound is not particularly limited, but the aqueous solution preferably contains at least sodium fluorozirconate as the inorganic fluorine compound and at least sodium dihydrogenphosphate as the phosphate compound.

The concentration of the phosphate compound in the aqueous solution is, from the standpoint of enhancing the on-press developability and scumming resistance, preferably 0.01 mass% or more, more preferably 0.1 mass% or more, and in view of solubility, preferably 20 mass% or less, more preferably 5 mass% of less.

The ratio of respective compounds in the aqueous solution is not particularly limited, but the mass ratio between the inorganic fluorine compound and the phosphate compound is preferably from 1/200 to 10/1, more preferably from 1/30 to 2/1.

The temperature of the aqueous solution is preferably 20°C or more, more preferably 40°C or more, and preferably 100°C or less, more preferably 80°C or less.

The pH of the aqueous solution is preferably 1 or more, more preferably 2 or more, and preferably 11 or less, more preferably 5 or less.

The method for the pore-sealing treatment with an aqueous solution containing an inorganic fluorine compound is not particularly limited, but examples thereof include a dipping method and a spray method. One of these methods may be used alone once or multiple times, or two or more species thereof may be used in combination.

In particular, a dipping method is preferred. In the case of performing the treatment by using a dipping method, the treating time is preferably 1 second or more, more preferably 3 seconds or more, and preferably 100 seconds or less, more preferably 20 seconds or less.

Examples of the pore-sealing treatment with water vapor include a method of continuously or discontinuously bringing water vapor under applied pressure or normal pressure into contact with the anodic oxide film.

The temperature of the water vapor is preferably 80°C or more, more preferably 95°C or more, and preferably 105°C or less.

The pressure of the water vapor is preferably from (atmospheric pressure - 50 mmAq) to (atmospheric pressure + 300 mmAq) (from 1.008×10⁵ to 1.043×10⁵ Pa).

The time period for which water vapor is contacted is preferably 1 second or more, more preferably 3 seconds or more, and preferably 100 seconds or less, more preferably 20 seconds or less.

Examples of the pore-sealing treatment with hot water include a method of dipping the aluminum plate having formed thereon the anodic oxide film in hot water.

The hot water may contain an inorganic salt (e.g., phosphate) or an organic salt.

The temperature of the hot water is preferably 80°C or more, more preferably 95°C or more, and preferably 100°C or less.

The time period for which the aluminum plate is dipped in hot water is preferably 1 second or more, more preferably 3 seconds or more, and preferably 100 seconds or less, more preferably 20 seconds or less.

In the present invention, a treatment for enlarging micropores of the anodic oxide film described in JP-A-2001-322365 may be performed in advance of the pore-sealing treatment. Furthermore, after the pore-sealing treatment, a surface-hydrophilizing treatment may also be performed.

As for the hydrophilizing treatment, an alkali metal silicate method described in U.S. Patents 2,714,066, 3,181,461, 3,280,734 and 3,902,734 is known. In this method, the support is dipped or electrolyzed in an aqueous solution of sodium silicate or the like. Other examples of the method include a treatment with potassium fluorozirconate described in JP-B-36-22063, and a treatment with polyvinylphosphonic acid described in U.S. Patents 3,276,868, 4,153,461 and 4,689,272.

In the case where a support insufficient in the hydrophilicity on the surface, such as polyester film, is used as the support of the present invention, a hydrophilic layer is preferably coated to render the surface hydrophilic. The hydrophilic layer is preferably a hydrophilic layer formed by coating a coating solution containing a colloid of an oxide or hydroxide of at least one element selected from beryllium, magnesium, aluminum, silicon, titanium, boron, germanium, tin, zirconium, iron, vanadium, antimony and a transition metal described in JP-A-2001-199175, a hydrophilic layer having an organic hydrophilic matrix obtained by crosslinking or pseudo-crosslinking an organic hydrophilic polymer described in JP-A-2002-79772, a hydrophilic layer having an inorganic hydrophilic matrix obtained by sol-gel conversion comprising hydrolysis and condensation reaction of polyalkoxysilane, titanate, zirconate or aluminate, or a hydrophilic layer comprising an inorganic thin film having a metal oxide-containing surface. Among these, a hydrophilic layer formed by coating a coating solution containing a colloid of an oxide or hydroxide of silicon is more preferred.

In the case of using polyester film or the like as the support of the present invention, an antistatic layer is preferably provided on the hydrophilic layer side or opposite side of the support or on both sides. When an antistatic layer is provided between the support and the hydrophilic layer, this contributes to the enhancement of adhesion to the hydrophilic layer. Examples of the antistatic layer which can be used include a polymer layer having dispersed therein a metal oxide fine particle or a matting agent described in JP-A-2002-79772.

The support for use in the present invention preferably has a centerline average roughness of 0.10 to 1.2 µm. Within this range, good adhesion to the image forming layer, good press life and good scumming resistance can be obtained.

### (Backcoat Layer)

After the support is subjected to a surface treatment or the undercoat layer is formed, a backcoat may be provided on the back surface of the support, if desired.

Suitable examples of the backcoat include a coat layer comprising an organic polymer compound described in JP-A-5-45885 and a coat layer comprising a metal oxide obtained by hydrolyzing and polycondensing an organic or inorganic metal compound described in JP-A-6-35174. In particular, it is preferred to use an alkoxy compound of silicon, such as Si(OCH₃)₄, Si(OC₂H₅)₄, Si(OC₃H₇)₄ and Si(OC₄H₉)₄, because the raw material is inexpensive and easily available.

### (Undercoat Layer)

In the lithographic printing plate precursor used in the present invention, particularly, in the case of an on-press developable lithographic printing plate precursor, an undercoat layer may be provided between the image forming layer and the support, if desired. The undercoat layer facilitates the separation of the image forming layer from the support in the unexposed area and therefore, the on-press developability is enhanced. Also, in the case of exposure with an infrared laser, the undercoat layer functions as a heat insulating layer and the heat generated upon exposure is prevented from diffusing into the support and is efficiently utilized, so that high sensitivity can be advantageously ensured.

Specific suitable examples of the compound for undercoat layer (undercoat compound) include a silane coupling agent having an addition-polymerizable ethylenic double bond reactive group described in JP-A-10-282679, and a phosphorus compound having an ethylenic double bond reactive group described in JP-A-2-304441.

A most preferred undercoat compound is a polymer resin obtained by copolymerizing a monomer having a support adsorbing group/a monomer having a hydrophilic group/a monomer having a crosslinking group.

An essential component of the polymer resin for undercoat is a support adsorbing group (an adsorptive group to the hydrophilic support surface). The presence or absence of adsorptivity to the hydrophilic support surface can be judged, for example, by the following method.

A coating solution is prepared by dissolving a test compound in a solvent capable of easily dissolving the compound, and the coating solution is coated and dried on a support to have a dry coated amount of 30 mg/m². Then, the support having coated thereon the test compound is thoroughly washed with a solvent capable of easily dissolving the compound and after measuring the residual amount of the test compound which is not removed by washing, the amount adsorbed to the support is calculated. Here, in the measurement of the residual amount, the amount of the residual compound may be directly determined or the residual amount may be calculated after determining the amount of the test compound dissolved in the washing solution. The quantitative determination of the compound may be performed, for example, by fluorescent X-ray measurement, reflection spectral absorbance measurement or liquid chromatography measurement. The compound having adsorptivity to the support is a compound which remains in an amount of 1 mg/m² or more even when the above-described washing treatment is performed.

The adsorptive group to the hydrophilic support surface is a functional group capable of bringing about chemical bonding (e.g., ionic bonding, hydrogen bonding, coordination bonding, bonding by intermolecular force) with a substance (e.g., metal, metal oxide) or functional group (e.g., hydroxyl group) present on the hydrophilic support surface. The adsorptive group is preferably an acid group or a basic group.

The acid group preferably has an acid dissociation constant (pKa) of 7 or less. Examples of the acid group include a phenolic hydroxyl group, a carboxyl group, - SO₃H, -OSO₃H, -PO₃H₂, -OPO₃H₂, -CONHSO₂-, -SO₂NHSO₂- and -COCH₂COCH₃. Among these, -OPO₃H₂ and -PO₃H₂ are preferred. Such an acid group may be a metal salt.

The basic group is preferably an onium group. Examples of the onium group include an ammonium group, a phosphonium group, an arsonium group, a stibonium group, an oxonium group, a sulfonium group, a selenonium group, a stannonium group and an iodonium group. Among these, an ammonium group, a phosphonium group and a sulfonium group are preferred, an ammonium group and a phosphonium group are more preferred, and an ammonium group is most preferred.

Particularly preferred examples of the monomer having an adsorptive group include the compounds represented by the following formulae (III) and (IV).

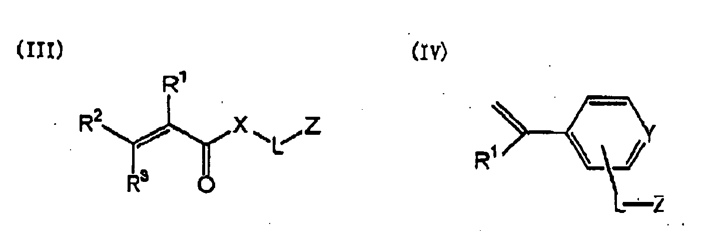

In formula (III), R¹, R² and R³ each independently represents a hydrogen atom, a halogen atom or an alkyl group having from 1 to 6 carbon atoms. R¹, R² and R³ each is independently preferably a hydrogen atom or an alkyl group having from 1 to 6 carbon atoms, more preferably a hydrogen atom or an alkyl group having from 1 to 3 carbon atoms, and most preferably a hydrogen atom or a methyl group, In particular, R² and R³ each is preferably a hydrogen atom,

In formula (III), X represents an oxygen atom (-O-) or an imino (-NH-). X is preferably an oxygen atom. In formula (III), L represents a divalent linking group. L is preferably a divalent aliphatic group (e.g., alkylene, substituted alkylene, alkenylene, substituted alkenylene, alkynylene, substituted alkynylene), a divalent aromatic group (e.g., arylene, substituted arylene), a divalent heterocyclic group, or a combination of such a group with an oxygen atom (-O-), a sulfur atom (-S-), an imino (-NH-), a substituted imino (-NR-, wherein R is an aliphatic group, an aromatic group or a heterocyclic group) or a carbonyl (-CO-).

The aliphatic group may have a cyclic structure or a branched structure. The number of carbon atoms in the aliphatic group is preferably from 1 to 20, more preferably from 1 to 15, and most preferably from 1 to 10. The aliphatic group is preferably a saturated aliphatic group rather than an unsaturated aliphatic group. The aliphatic group may have a substituent. Examples of the substituent include a halogen atom, a hydroxyl group, an aromatic group and a heterocyclic group.

The number of carbon atoms in the aromatic group is preferably from 6 to 20, more preferably from 6 to 15, and most preferably from 6 to 10. The aromatic group may have a substituent. Examples of the substituent include a halogen atom, a hydroxyl group, an aliphatic group, an aromatic group and a heterocyclic group.

The heterocyclic group preferably has a 5- or 6-membered ring as the heterocyclic ring. The heterocyclic ring may be condensed with another heterocyclic ring, an aliphatic ring or an aromatic ring. The heterocyclic group may have a substituent. Examples of the substituent include a halogen atom, a hydroxyl group, an oxo group (=O), a thioxo group (=S), an imino group (=NH), a substituted imino group (=N-R, wherein R is an aliphatic group, an aromatic group or a heterocyclic group), an aliphatic group, an aromatic group and a heterocyclic group.

L is preferably a divalent linking group containing a plurality of polyoxyalkylene structures. The polyoxyalkylene structure is more preferably a polyoxyethylene structure. In other words, L preferably contains -(OCH₂CH₂)ₙ-(wherein n is an integer of 2 or more).

In formula (III), Z is a functional group which adsorbs to the hydrophilic support surface, and Y is a carbon atom or a nitrogen atom. When Y is a nitrogen atom and L is connected on Y to form a quaternary pyridinium group, the quaternary pyridinium group itself exhibits adsorptivity and therefore, Z is not essential.

Representative examples of the monomers represented by formulae (III) and (IV) are set forth below.

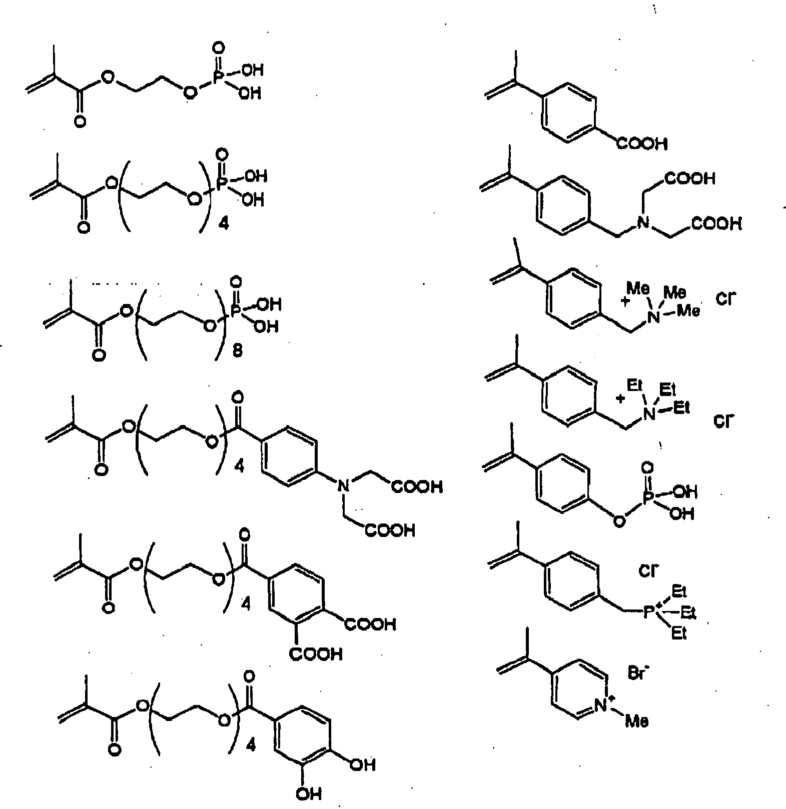

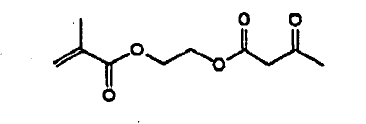

Suitable examples of the hydrophilic group of the polymer resin for undercoat, which can be used in the present invention, include a hydroxy group, a carboxyl group, a carboxylate group, a hydroxyethyl group, a polyoxyethyl group, a hydroxypropyl group, a polyoxypropyl group, an amino group, an aminoethyl group, an aminopropyl group, an ammonium group, an amido group, a carboxymethyl group, a sulfonic acid group and a phosphoric acid group. In particular, a monomer having a sulfonic acid group exhibiting high hydrophilicity is preferred. Specific examples of the monomer having a sulfonic acid group include a sodium salt and an amine salt of methallyloxybenzenesulfonic acid, allyloxybenzenesulfonic acid, allylsulfonic acid, vinylsulfonic acid, allylsulfonic acid, p-styrenesulfonic acid, methallylsulfonic acid, acrylamide tert-butylsulfonic acid, 2-acrylamide-2-methylpropanesulfonic acid and (3-acryloyloxypropyl)butylsulfonic acid. Among these, sodium 2-acrylamide-2-methylpropanesulfonate is preferred because of its hydrophilic performance and easy handleability in the synthesis.

The water-soluble polymer resin for undercoat layer, which is used in the present invention, preferably has a crosslinking group. By virtue of the crosslinking group, the adhesion to the image area can be enhanced. For imparting the crosslinking property to the polymer resin for undercoat layer, a crosslinking functional group such as ethylenically unsaturated bond may be introduced into the side chain of the polymer or may be introduced by forming a salt structure with a compound having a substituent with a counter charge to the polar substituent of the polymer resin and having an ethylenically unsaturated bond.

Examples of the polymer having an ethylenically unsaturated bond in the side chain of the molecule include a polymer which is a polymer of acrylic or methacrylic acid ester or amide and in which the ester or amide residue (R in -COOR or -CONHR) has an ethylenically unsaturated bond.

Examples of the residue (R above) having an ethylenically unsaturated bond include -(CH₂)ₙCR₁=CR₂R₃, -(CH₂O)ₙCH₂CR₁=CR₂R₃, -(CH₂CH₂O)ₙCH₂CR₁=CR₂R₃, -(CH₂)ₙNH-CO-O-CH₂CR₁-CR₂R₃, -(CH₂)ₙ-O-CO-CR₁=CR₂R₃ and -(CH₂CH₂O)₂-X (wherein R₁ to R₃ each represents a hydrogen atom, a halogen atom or an alkyl, aryl, alkoxy or aryloxy group having a carbon number of 1 to 20, R₁ and R₂ or R₃ may combine with each other to form a ring, n represents an integer of 1 to 10, and X represents a dicyclopentadienyl residue).

Specific examples of the ester residue include -CH₂CH=CH₂ (described in JP-B-7-21633), -CH₂CH₂O-CH₂CH=CH₂, -CH₂C(CH₃)=CH₂, -CH₂CH=CH-C₆H₅, - CH₂CH₂OCOCH=CH-C₆H₅, -CH₂CH₂-NHCOO-CH₂CH=CH₂ and -CH₂CH₂O-X (wherein X represents a dicyclopentadienyl residue).

Specific examples of the amide residue include -CH₂CH=CH₂, -CH₂CH₂O-Y (wherein Y represents a cyclohexene residue) and -CH₂CH₂OCO-CH=CH₂.

The monomer having a crosslinking group of the polymer resin for undercoat layer is suitably an acrylic or methacrylic acid ester or aide having the above-described crosslinking group.

The content of the crosslinking group (content of the radical-polymerizable unsaturated double bond as determined by iodine titration) in the polymer resin for undercoat layer is preferably from 0.1 to 10.0 mmol, more preferably from 1.0 to 7.0 mmol, and most preferably from 2.0 to 5.5 mmol, per g of the polymer resin. Within this range, both good sensitivity and good scumming resistance can be established and good storage stability can be obtained.

The mass average molecular weight of the polymer resin for undercoat layer is preferably 5,000 or more, more preferably from 10,000 to 300,000, and the number average molecular weight is preferably 1,000 or more, more preferably from 2,000 to 250,000. The polydispersity (mass average molecular weight/number average molecular weight) is preferably from 1.1 to 10.

The polymer resin for undercoat layer may be any polymer such as random polymer, block polymer or graft polymer but is preferably a random polymer.

One of these polymer resins for undercoat may be used alone, or two or more species thereof may be used as a mixture. The coated amount (solid content) of the undercoat layer is preferably from 0.1 to 100 mg/m², more preferably from 1 to 30 mg/m².

From the standpoint of more enhancing the adhesive property and in view of on-press developability and scumming resistance, it is a particularly preferred embodiment that the compound having a polymerizable group further has a support adsorbing group and a hydrophilicity-imparting group in the molecule. The support adsorbing group as used herein indicates a group capable of bringing about, in general, ion bonding, hydrogen bonding, coordination bonding or bonding by intermolecular force with a metal, metal oxide, hydroxyl group or the like present on the support subjected to, for example, an anodization treatment or a hydrophilization treatment. The support adsorbing group is preferably an acid group or an onium group. The acid is preferably a group having an acid dissociation constant (pKa) of 7 or less, and specific examples thereof include -COOH, -SO₃H, -OSO₃H, -PO₃H₂, -OPO₃H₂, - CONHSO₂- and -SO₂NHSO₂-. Among these, -PO₃H₂ is preferred. The onium group is an onium group derived from an atom belonging to Group 5B (Group 15) or Group 6B (Group 16) of the Periodic Table, preferably an onium group derived from a nitrogen atom, a phosphorus atom or a sulfur atom, more preferably an onium group derived from a nitrogen atom. Examples of the hydrophilicity-imparting group include an ethylene oxide group (-OCH₂CH₂-) and a sulfonic acid group.

The coated amount (solid content) of the undercoat layer is preferably from 0.1 to 100 mg/m², more preferably from 3 to 30 mg/m².

### [Exposure]

The light source used for imagewise exposing the lithographic printing plate precursor used in the present invention with a laser is not particularly limited but in the case of an infrared laser, a solid or semiconductor laser emitting an infrared ray at a wavelength of 760 to 1,200 nm is preferred. The output of the infrared laser is preferably 100 mW or more and in order to shorten the exposure time, a multi-beam laser device is preferably used.

The exposure time is preferably 20 micro-seconds or less per one picture element. The irradiation energy amount is preferably from 10 to 300 mJ/cm².

### [Printing]

In the present invention, the lithographic printing plate precursor used in the present invention after the above-described imagewise exposure by an infrared laser is treated with an aqueous solution containing a basic coloring matter and then loaded on a printing press for performing printing. When printing is performed by supplying an aqueous component and an oily ink, the image forming layer cured upon exposure receives the oily ink in the exposed area of the image forming layer. On the other hand, in the unexposed area, the remaining uncured image forming layer is completely removed with the supplied aqueous component and/or oily ink to reveal the hydrophilic surface, and the aqueous component adheres to the revealed hydrophilic surface, thereby initiating the printing. Here, either the aqueous component or the oily ink may be first supplied to the plate surface but from the standpoint of preventing the aqueous component from being contaminated by the image forming layer in the unexposed area, the oily ink is preferably first supplied. As for the aqueous component and the oily ink, a fountain solution and a printing ink for normal lithographic printing are used.

### [Examples]

The present invention is described in greater detail below by referring to Examples, but the present invention is not limited thereto.

### [Production of Support]

A 0.3 mm-thick aluminum plate (construction material: 1050) was degreased with an aqueous 10 mass% sodium aluminate solution at 50°C for 30 seconds to remove the rolling oil on the surface. Thereafter, the aluminum plate surface was grained using three nylon brushes each implanted with bundled bristles having a diameter of 0.3 mm and using a water suspension (specific gravity: 1.1 g/cm³) of pumice having a median diameter of 25 µm, and then thoroughly washed with water. This plate was etched by dipping it in an aqueous 25 mass% sodium hydroxide solution at 45°C for 9 seconds and after washing with water, dipped in 20 mass% nitric acid at 60°C for 20 seconds, followed by washing with water. At this time, the etched amount of the grained surface was about 3 g/m².

Subsequently, the aluminum plate was subjected to continuous electrochemical surface-roughening treatment by using an AC voltage at 60 Hz. Here, the electrolytic solution used was an aqueous 1 mass% nitric acid solution (containing 0.5 mass% of aluminum ion) and the liquid temperature was 50°C. This electrochemical surface-roughening treatment was performed using an AC power waveform which was a trapezoidal rectangular waveform such that the time TP necessary for the current value to reach the peak from zero was 0.8 msec and the duty ratio was 1:1, and employing a carbon electrode as the counter electrode. For the auxiliary anode, ferrite was used. The current density was 30 A/dm² in terms of the peak current value, and 5% of the current flowing from the power source was split to the auxiliary anode. The quantity of electricity in the nitric acid electrolysis was 175 C/dm² when the aluminum plate was serving as the anode. Furthermore, the aluminum plate was washed with water by spraying.

Thereafter, the aluminum plate was subjected to electrochemical surface-roughening treatment in the same manner as in the nitric acid electrolysis above by using an electrolytic solution comprising an aqueous 0.5 mass% hydrochloric acid solution (containing 0.5 mass% of aluminum ion) at a liquid temperature of 50°C under the condition that the quantity of electricity was 50 C/dm² when the aluminum plate was serving as the anode, and then washed with water by spraying. This plate was treated using an electrolytic solution comprising 15 mass% sulfuric acid (containing 0.5 mass% of aluminum ion) at a current density of 15 A/dm² to provide a DC anodic oxide film of 2.5 g/m², and then subjected to washing with water and drying, thereby obtaining Support A. The centerline average roughness (Ra) of this support was measured using a needle having a diameter of 2 µm and found to be 0.51 µm.

### [Production of Lithographic Printing Plate Precursor (1)]

The following undercoat solution was coated on the support produced above, by using a bar to have a dry coated amount of 10 mg/m² and then dried in an oven at 80°C for 20 seconds to form an undercoat layer. Furthermore, Coating Solution (1) for Image Forming Layer having a composition shown below was coated on the obtained undercoat layer by using a bar and dried in an oven at 100°C for 60 seconds to form an image forming layer having a dry coated amount of 1.0 g/m², thereby obtaining Lithographic Printing Plate Precursor (1).

### Undercoat Solution:

| | |
|---|---|
| Compound B shown below | 0.017 g |
| Methanol | 9.00 g |
| Water | 1.00 g |

### Compound (B):

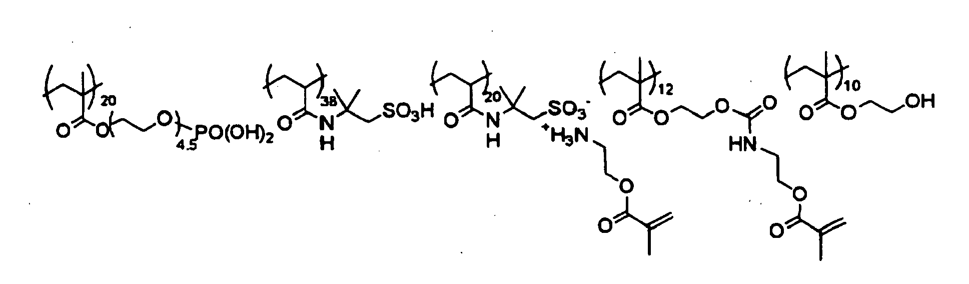

### Coating Solution (1) for Image Forming Layer:

| | |
|---|---|
| Binder Polymer (1) | 0.162 g |
| Polymerization Initiator (1) | 0.100 g |
| Infrared Absorbent (1) | 0.020 g |
| Polymerizable compound, Aronics^{®} M-215 (produced by Toagosei Co., Ltd.) | 0.385 g |
| Fluorine-Containing Surfactant (1) | 0.044 g |
| Methyl ethyl ketone | 1.091 g |
| 1-Methoxy-2-propanol | 8.609 g |
| Microgel synthesized as follows | 2.640 g |
| Layered Compound Water Dispersion (1) | 2.500 g |

### Binder Polymer (1):

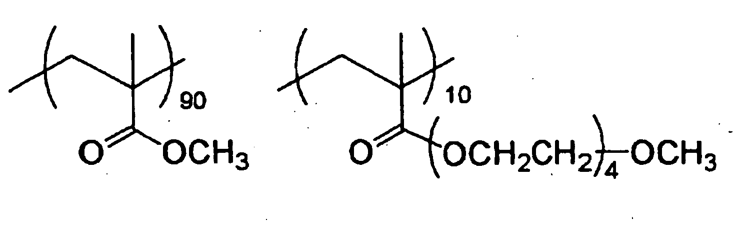

### Polymerization Initiator (1):

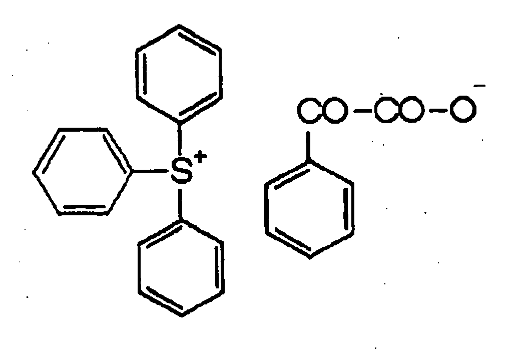

### Infrared Absorbent (1):

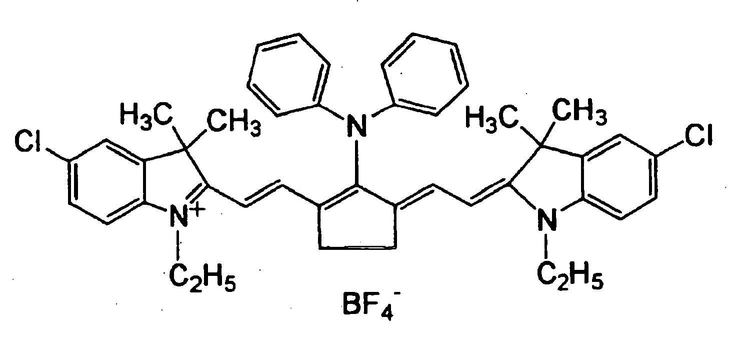

### Fluorine-Containing Surfactant (1):

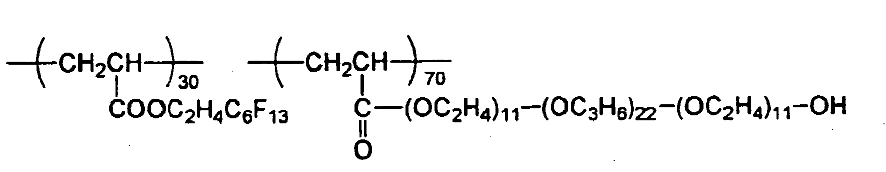

### <Preparation of Layered Compound Water Dispersion (1))

In 193.6 g of ion exchanged water, 6.4 g of synthetic mica, SOMASIF^{®} ME-100 (produced by CO-OP Chemical Co., Ltd.), was added and dispersed using a homogenizer until the average particle diameter (as determined by the laser scattering method) became 3 µm. The dispersed inorganic particles obtained had an aspect ratio of 100 or more.

### <Synthesis of Microgel>

As the oil phase component, 10 g of a trimethylolpropane and xylene diisocyanate adduct (Takenate^{®} D-110N, produced by Mitsui Takeda Chemicals, Inc., a 75 mass% ethyl acetate solution), 6.00 g of Aronics^{®} M-215 (produced by Toagosei Co., Ltd.) and 0.12 g of Pionin^{®} A-41C (produced by Takemoto Oil & Fat Co., Ltd.) were dissolved in 16.67 g of ethyl acetate. As the aqueous phase component, 37.5 g of an aqueous 4 mass% PVA-205 solution was prepared. The oil phase component and the aqueous phase component were mixed and emulsified using a homogenizer at 12,000 rpm for 10 minutes. The resulting emulsified product was added to 25 g of distilled water and the mixture was stirred at room temperature for 30 minutes and then stirred at 40°C for 2 hours. The thus-obtained microgel solution was diluted with distilled water to a solid content concentration of 15 mass%. The average particle diameter was 0.2 µm.

### [Production of Lithographic Printing Plate Precursor (2)]

The following undercoat solution was coated on the support produced above, by using a bar to have a dry coated amount of 10 mg/m² and then dried in an oven at 80°C for 20 seconds to form an undercoat layer. Furthermore, Coating Solution (2) for Image Forming Layer having a composition shown below was bar-coated on the obtained undercoat layer and dried in an oven at 100°C for 60 seconds to form an image forming layer having a dry coated amount of 1.0 g/m², thereby obtaining a lithographic printing plate precursor. Subsequently, the coating solution for protective layer having a composition shown below was bar-coated on the image forming layer and then dried in an oven at 120°C for 60 seconds to form a protective layer having a dry coated amount of 0.15 g/m², whereby a lithographic printing plate precursor was obtained.

### <Production of Coating Solution (2) for Image Forming Layer>

Coating Solution (2) for Image Forming Layer was obtained by mixing the following Photosensitive Solution (1) and Microgel Solution (1) immediately before coating and stirring the mixture.

### Photosensitive Solution (1):

| | |
|---|---|
| Binder Polymer (1) | 0.162 g |
| Polymerization Initiator (1) | 0.100 g |
| Infrared Absorbing Dye (1) | 0.020 g |
| Polymerizable monomer, Aronics^{®} M-215 (produced by Toagosei Co., Ltd.) | 0.385 g |
| Fluorine-Containing Surfactant (1) | 0.044 g |
| Methyl ethyl ketone | 1.091 g |
| 1-Methoxy-2-propanol | 8.609 g |

### Microgel Solution (1):

| | |
|---|---|
| Microgel solution synthesized as above | 2.640 g |
| Water | 2.425 g |

### Coating Solution for Protective Layer:

| | |
|---|---|
| Layered Compound Water Dispersion (1) | 1.5 g |
| | |
| Polyvinyl alcohol PVA105 (produced by Kuraray Co., Ltd., saponification degree: 98.5 mol%, polymerization degree: 500) | 0.06 g |
| | |
| Polyvinylpyrrolidone K30 (produced by Tokyo Kasei Kogyo Co., Ltd., molecular weight Mw: 40,000) | 0.01 g |
| | |
| Vinylpyrrolidone/vinyl acetate copolymer LUVITEC^{®} VA64W (produced by ISP, copolymerization ratio: 6/4) | 0.01 g |
| | |
| Nonionic surfactant Emalex^{®} 710 (produced by Nihon Emulsion Co., Ltd.) | 0.01 g |
| | |
| Ion exchanged water | 6.0 g |

### [Production of Lithographic Printing Plate Precursor (3) for Comparison]

Lithographic Printing Plate Precursor (3) for comparison was produced by performing the same operation as in the production of Lithographic Printing Plate Precursor (2) except for not coating the coating solution for protective layer.

### [Production of Processing Solution (Dyeing Solution)]

Processing Solutions 1 to 4 shown in Table 1 below were produced. In the Table, the unit of numerals is [g].

**Table 1 Composition of Processing Solution**

| | Processing Solution 1 | Processing Solution 2 | Processing Solution 3 for Comparison | Processing Solution 4 for Comparison |
|---|---|---|---|---|
| Water | 944 | 949 | 957 | 947 |
| Methylene Blue FZconc (produced by Hodogaya Chemical Co., Ltd.) | 3 | | | |
| Crystal Violet (produced by Hodogaya Chemical Co., Ltd.) | | 3 | | |
| Carbon black (HIMICRON^{®}-K- BLACK #7360, produced by Mikuni Color, Ltd., 16.5% water dispersion) | | | 8 | |
| Benzyl alcohol | 10 | | | 10 |
| N-Phenylethanolamine | | 5 | 5 | |
| Gum arabic | 10 | 10 | | 10 |
| Enzyme-modified potato starch | 20 | 20 | 20 | |
| Soybean polysaccharide (10% aqueous solution; viscosity: 14 to 18 mPa/sec) | | | | 20 |
| Dioctylsulfosuccinic acid ester | 5 | 5 | | 5 |
| Polyoxyethylene (addition molar number: 10) diglycerin | | | 5 | |
| Ammonium primary phosphate | 1 | 1 | 1 | I |
| Citric acid | 1 | | 1 | 1 |
| Sodium hexametaphosphate | | 1 | | |
| EDTA-4 sodium salt | 1 | 1 | 1 | 1 |
| Ethylene glycol | 5 | 5 | | 5 |
| Glycerin | | | 2 | |
| Total | 1000 | 1000 | 1000 | 1000 |

### [Examples 1 to 4 and Comparative Examples 1 to 8]

### 1. Exposure, Dyeing and Printing

Lithographic Printing Plate Precursors (1) to (3) obtained above each was exposed using Trendsetter 3244VX (manufactured by Creo) having mounted thereon a water-cooling 40 W infrared semiconductor laser, under the conditions that the output was 9 W, the rotation number of outer drum was 210 rpm and the resolution was 2,400 dpi. The exposure image was prepared to contain a 40% halftone dot image of 200 lpi and a solid area (100% halftone dot image).

The exposed printing plate precursor obtained was subjected to a treatment of manually rubbing the plate surface for 60 seconds with an absorbent cotton impregnated with the processing solution above, whereby the unexposed area of the image forming layer was removed and at the same time, the exposed area was stained. Subsequently, the plate surface was washed with tap water by using a shower and then naturally dried.

Thereafter, the printing plate precursor was loaded on a cylinder of a printing press, SOR-M, manufactured by Heidelberg and after supplying a fountain solution and an ink by using fountain solution (ECOLITY^{®} 2 (produced by Fuji Photo Film Co., Ltd.)/water = 4/96 (by volume)) and GEOS-G(N)^{®} Black Ink (produced by Dai-Nippon Ink & Chemicals, Inc.), printing on 100 sheets was performed at a printing speed of 6,000 sheets per hour. The number of printing sheets required until the on-press development of the image forming layer in the unexposed area was completed on the printing press and ink transfer to the printing sheet did not occur was counted and evaluated as the on-press developability, as a result, when using any lithographic printing plate precursor, a printed matter free from contamination in the non-image area could be obtained within 100 sheets.

### 2. Evaluation of Image Visibility, Halftone Dot Measurability and Inking Property

### (1) Image Visibility

The lithographic printing plate precursor after exposure was dyed with the dyeing solution, washed with water and dried. Thereafter, the L* values of exposed area (solid area) and unexposed area were measured by a color-difference meter (Color and Color-Difference Meter CR-221, manufactured by Minolta Co., Ltd.) and from the absolute value of the difference therebetween, the lightness difference ΔL was determined. A larger numerical value of this ΔL index indicates higher visibility and is more preferred.

In Comparative Examples not using the dyeing solution, the measurement by the color-difference meter was performed immediately after the imagewise exposure. The results are shown in Table 2.

### (2) Halftone Dot Measurability

The lithographic printing plate precursor after exposure was dyed with the dyeing solution, washed with water and dried, and the area value of 40% halftone dot was measured using a halftone dot meter (iCPlate II, manufactured by Gretag-Macbeth). In Comparative Examples not using the dyeing solution, the measurement by the halftone dot meter was performed immediately after the imagewise exposure. The results are shown in Table 2.

### (3) Inking Property

The on-press development of the lithographic printing plate precursor is performed at the initial stage of printing and thereafter, the image area is gradually inked to cause increase in the image density. The number of sheets required until the ink image density exceeded 1.6 was defined as the number of inked sheets. A smaller number of inked sheets indicates less occurrence of paper loss at the start and is more preferred.

In Comparative Examples not using the dyeing solution, the printing plate precursor after imagewise exposure was loaded as it is on the printing press and printing was performed. The results are shown in Table 2.

**Table 2 Evaluation Results**

| | Lithographic Printing Plate Precursor | Dyeing Solution | Image Visibility (ΔL) | Halftone Dot Measur ability | Inkling Property |
|---|---|---|---|---|---|
| Example 1 | Lithographic Printing Plate Precursor (1) | Processing Solution (1) | 13 | measurable (43%) | 15 sheets |
| Example 2 | Lithographic Printing Plate Precursor (1) | Processing Solution (2) | 16 | measurable (43%) | 15 sheets |
| Example 3 | Lithographic Printing Plate Precursor (2) | Processing Solution (1) | 11 | measurable (43%) | 15 sheets |
| Example 4 | Lithographic Printing Plate Precursor (2) | Processing Solution (2) | 14 | measurable (43%) | 15 sheets |
| Comparative Example 1 | Lithographic Printing Plate Precursor (1) | Processing Solution (3) | 4 | immeasurable | 15 sheets |
| Comparative Example 2 | Lithographic Printing Plate Precursor (1) | Processing Solution (4) | 3 | immeasurable | 15 sheets |
| Comparative Example 3 | Lithographic Printing Plate Precursor (2) | Processing Solution (3) | 4 | immeasurable | 15 sheets |
| Comparative Example 4 | Lithographic Printing Plate Precursor (2) | Processing Solution (4) | 3 | immeasurable | 15 sheets |
| Comparative Example 5 | Lithographic Printing Plate Precursor (3) | Processing Solution (2) | 4 | immeasurable | 15 sheets |
| Comparative Example 6 | Lithographic Printing Plate Precursor (1) | not used | 0 | immeasurable | 30 sheets |
| Comparative Example 7 | Lithographic Printing Plate Precursor (2) | not used | 0 | immeasurable | 40 sheets |
| Comparative Example 8 | Lithographic Printing Plate Precursor (3) | not used | 0 | immeasurable | 30 sheets |

As apparent from the results in Table 2, in Examples using the lithographic printing plate precursor and dyeing processing solution used in the present invention, the image visibility, halftone dot measurability and inking property all are good.

According to the present invention, an on-press developable lithographic printing plate precursor free from ink contamination is obtained and in addition, a lithographic printing plate precursor assured of good plate inspection and good inking property is obtained. Also, according to the present invention, the image quality can be controlled and a printing method ensuring a stable printing quality can be provided.

## Claims

1. A method for processing a lithographic printing plate precursor comprising a support and an image recording layer comprising a radical polymerization initiator, a radical polymerizable compound and a compound which interacts with a basic coloring matter, and being removable by at least one of a printing ink and a fountain solution, which method comprises the steps of
i) imagewise exposing the plate, and
ii) bringing the exposed plate into contact with an aqueous solution containing a basic coloring matter;
wherein the staining of the image area and the removal of the non-image area are simultaneously performed.

2. The method of claim 1, wherein the compound interacting with a basic coloring matter is an inorganic compound.

3. The method of claim 1, wherein the absorption spectrum of the basic coloring matter has a λₘₐₓ of 400-700 nm.

4. The method of claim 1, wherein the absorption spectrum of the image recording layer has no λₘₐₓ in the region of 400-700 nm.

5. The method of claim 2, wherein the inorganic compound is layered compound having an aspect ratio of 20 or more.

6. The method of claim 1, which further comprises the step of
iii) drying the plate.

7. The method of claim 6, which further comprises the step of
iv) measuring a halftone dot area or density of the image by a halftone dot area meter or a densitometer.

## Patentansprüche

1. Verfahren zur Herstellung eines Lithografie-Druckplattenvorläufers, der einen Träger und eine Bildaufzeichnungsschicht umfasst, die einen Radikalpolymerisationsinitiator, eine radikalisch polymerisierbare Verbindung und eine Verbindung, die mit einem basischen Färbemittel wechselwirkt und die durch mindestens eine Drucktinte und/oder ein Feuchtmittel entfernbar ist, umfasst, wobei das Verfahren die Schritte
(i) bildweises Belichten der Platte und
(ii) Kontaktieren der belichteten Platte mit einer wässrigen Lösung, die ein basisches Färbemittel enthält,
umfasst, wobei das Färben des Bildbereichs und das Entfernen des Nicht-Bildbereichs gleichzeitig durchgeführt werden.

2. Verfahren gemäss Anspruch 1, wobei die Verbindung, die mit einem basischen Färbemittel wechselwirkt, eine anorganische Verbindung ist.

3. Verfahren gemäss Anspruch 1, wobei das Absorptionsspektrum des basischen Färbemittels ein λₘₐₓ von 400 bis 700 nm aufweist.

4. Verfahren gemäss Anspruch 1, wobei das Absorptionsspektrum der Bildaufzeichnungsschicht kein λₘₐₓ im Bereich von 400 bis 700 nm aufweist.

5. Verfahren gemäss Anspruch 2, wobei die anorganische Verbindung eine geschichtete Verbindung ist, die ein Seitenverhältnis von 20 oder mehr aufweist.

6. Verfahren gemäss Anspruch 1, das weiterhin den Schritt
(iii) Trocknen der Platte
umfasst.

7. Verfahren gemäss Anspruch 6, das weiterhin den Schritt
(iv) Messen eines Rasterpunktbereichs oder der Bilddichte durch ein Rasterpunktbereich-Messgerät oder ein Densitometer
umfasst.

## Revendications

1. Procédé pour traiter un précurseur de plaque d'impression lithographique comprenant un support et une couche d'enregistrement d'image comprenant un initiateur de polymérisation radicalaire, un composé polymérisable par voie radicalaire et un composé qui interagit avec une matière colorante de base, et pouvant être enlevé par au moins l'une parmi une encre d'impression et une solution mouillante, ledit procédé comprenant les étapes consistant à :
i) exposer la plaque image par image, et
ii) amener la plaque exposée au contact d'une solution aqueuse contenant une matière colorante de base ;
dans lequel la coloration de la zone d'image et l'enlèvement de la zone sans image sont effectués simultanément.

2. Procédé selon la revendication 1, dans lequel le composé interagissant avec une matière colorante de base est un composé inorganique.

3. Procédé selon la revendication 1, dans lequel le spectre d'absorption de la matière colorante de base a une λₘₐₓ de 400 à 700 nm.

4. Procédé selon la revendication 1, dans lequel le spectre d'absorption de la couche d'enregistrement d'image n'a pas de λₘₐₓ dans la région de 400 à 700 nm.

5. Procédé selon la revendication 2, dans lequel le composé inorganique est un composé stratifié ayant un rapport dimensionnel de 20 ou davantage.

6. Procédé selon la revendication 1, qui comprend en outre l'étape consistant à :
iii) sécher la plaque.

7. Procédé selon la revendication 6, qui comprend en outre l'étape consistant à :
iv) mesurer une zone de points de simili (demi-ton) ou une densité de l'image au moyen d'un mesureur de zone de points de simili ou d'un densitomètre.
